# EUROPEAN PATENT SPECIFICATION

(11) **EP 4 294 147 B1**
(45) Date of publication and mention of the grant of the patent: **22.04.2026**
(21) Application number: 23164757.9
(22) Date of filing: 28.03.2023
(51) Int. Cl.: H10B 41/27, H10B 43/27

(54) **SEMICONDUCTOR MEMORY DEVICES AND ELECTRONIC SYSTEMS**
HALBLEITERSPEICHERANORDNUNGEN UND ELEKTRONISCHE SYSTEME
DISPOSITIFS DE MÉMOIRE À SEMI-CONDUCTEURS ET SYSTÈMES ÉLECTRONIQUES

(30) Priority: 14.06.2022 KR 20220072400
(43) Date of publication of application: 20.12.2023
(73) Proprietor: Samsung Electronics Co., Ltd., Suwon-si, Gyeonggi-do 16677 (KR)
(72) Inventor: KIM, Ji Young, 16677 Suwon-si, Gyeonggi-do (KR); KIM, Do Hyung, 16677 Suwon-si, Gyeonggi-do (KR); KIM, Ji Won, 16677 Suwon-si, Gyeonggi-do (KR); SUNG, Suk Kang, 16677 Suwon-si, Gyeonggi-do (KR)
(74) Representative: Kuhnen & Wacker Patent- und Rechtsanwaltsbüro PartG mbB

(56) References cited:
- US-A1- 2021 375 914
- US-B2- 10 748 923

## Description

### BACKGROUND

### Field

The present disclosure relates to semiconductor memory devices and electronic systems including the same.

### Description of Related Art

US 2021/375914 A1 discloses 3D memory devices and methods for forming the same. In an example of this prior art document, a method for forming a 3D memory device is disclosed. A sacrificial layer on a substrate, a P-type doped semiconductor layer having an N-well on the sacrificial layer, and a dielectric stack on the P-type doped semiconductor layer are subsequently formed. A channel structure extending vertically through the dielectric stack and the P-type doped semiconductor layer is formed. The dielectric stack is replaced with a memory stack, such that the channel structure extends vertically through the memory stack and the P-type doped semiconductor layer. The substrate and the sacrificial layer are removed to expose an end of the channel structure. Part of the channel structure abutting the P-type doped semiconductor layer is replaced with a semiconductor plug.

US 10748923 B2 discloses a vertical memory device that includes gate electrodes on a substrate, a channel extending through the gate electrodes, and a contact plug extending through the gate electrodes. The gate electrodes are stacked in a first direction substantially vertical to an upper surface of the substrate and arranged to have a staircase shape including steps of which extension lengths in a second direction substantially parallel to the upper surface gradually increase from a lowermost level toward an uppermost level. A pad at an end portion of each of the gate electrodes in the second direction has a thickness greater than those of other portions thereof. The channel extends in the first direction. The contact plug extends in the first direction. The channel contacts the pad of a first gate electrode among the gate electrodes to be electrically connected thereto, and is electrically insulated from second gate electrodes among the gate electrodes.

As a semiconductor memory device capable of storing a high capacity of data therein is required in an electronic system, schemes for increasing a data storage capacity of the semiconductor memory device are being studied. A semiconductor memory device including memory cells arranged in a three-dimensional manner instead of memory cells arranged in a twodimensional manner has been proposed as one of the schemes for increasing the data storage capacity of the semiconductor memory device.

### SUMMARY

The invention is set out in the appended claims.

A technical purpose of the present disclosure is to provide a semiconductor memory device with improved product reliability.

Another technical purpose of the present disclosure is to provide an electronic system including a semiconductor memory device with improved product reliability.

Purposes according to the present disclosure are not limited to the above-mentioned purpose. Other purposes and advantages according to the present disclosure that are not mentioned may be understood based on following descriptions, and may be more clearly understood based on implementations according to the present disclosure. Further, it will be easily understood that the purposes and advantages according to the present disclosure may be realized using means shown in the claims and combinations thereof.

According to partial aspects of some implementations of the present disclosure, a semiconductor memory device includes a semiconductor layer including a first face and a second face opposite to the first face in a first direction directed upward from the first face to the second face; a source structure including: a plate disposed on the second face of the semiconductor layer; and a plug extending from the plate through the semiconductor layer; a plurality of gate electrodes disposed on the first face of the semiconductor layer and sequentially stacked on one an other; and a channel structure that extends through the plurality of gate electrodes and that is disposed on the plug, wherein the channel structure is electrically connected to the source structure.

According to partial aspects of some implementations of the present disclosure, a semiconductor memory device includes a source structure; a plurality of gate electrodes disposed on the source structure and sequentially stacked on one another; a channel structure that extends through the plurality of gate electrodes and that is electrically connected to the source structure; a dummy channel structure extending through the plurality of gate electrodes; and a word-line cutting structure arranged to cut the plurality of gate electrodes, wherein each of the dummy channel structure and the word-line cutting structure is spaced apart from the source structure along a direction parallel to an extension direction of the plurality of gate electrodes, and, wherein, in a first direction directed upward from the plurality of gate electrodes toward the source structure, a vertical level of each of a top face of the dummy channel structure and a top face of the word-line cutting structure is different from a vertical level of a top face of the channel structure.

According to partial aspects of some implementations of the present disclosure, a semiconductor memory device includes a peripheral circuit structure; and a cell structure stacked on the peripheral circuit structure, wherein the cell structure includes: a semiconductor layer including a first face facing the peripheral circuit structure and a second face opposite to the first face in a first direction directed upward from the first face to the second face; a source structure including: a plate disposed on the second face of the semiconductor layer; and a plug extending from the plate through the semiconductor layer; a mold structure disposed on the first face of the semiconductor layer, the mold structure including a plurality of gate electrodes sequentially stacked on one another; a channel structure that extends through the plurality of gate electrodes and that is electrically connected to the source structure; a bit-line disposed between the peripheral circuit structure and the mold structure, and electrically connected to the channel structure; a plurality of cell contacts disposed on the mold structure, wherein each of the plurality of cell contacts is electrically connected to at least one of the plurality of gate electrodes; a word-line cutting structure that extends through the mold structure and cuts the plurality of gate electrodes; and a dummy channel structure extending through the mold structure, wherein each of the mold structure, the plurality of cell contacts, and the word-line cutting structure is spaced apart from the plate of the source structure via the semiconductor layer along a direction parallel to the first face of the semiconductor layer, and wherein the channel structure is disposed on the plug.

According to partial aspects of some implementations of the present disclosure, an electronic system includes a main substrate; a semiconductor memory device disposed on the main substrate, wherein the semiconductor memory device includes a peripheral circuit structure and a cell structure stacked on the peripheral circuit structure; and a controller disposed on the main substrate and electrically connected to the semiconductor memory device, wherein the cell structure includes: a base layer including a first face and a second face opposite to the first face in a first direction directed upward from the first face to the second face; a source structure including a plug extending through the base layer, a plurality of gate electrodes disposed on the first face of the base layer and sequentially stacked on top of one another; a channel structure disposed on the plug and extending through the plurality of gate electrodes, wherein the channel structure is electrically connected to the source structure; a dummy channel structure disposed on the base layer and extending through the plurality of gate electrodes; and a word-line cutting structure that is disposed on the base layer and that cuts the plurality of gate electrodes; wherein, in the first direction, a vertical level of each of a top face of the dummy channel structure and a top face of the word-line cutting structure is different from a vertical level of a top face of the channel structure.

The specific details of other implementations are included in the detailed description and drawings.

### BRIEF DESCRIPTION OF DRAWINGS

The above and other aspects and features of the present disclosure will become more apparent by describing in detail implementations thereof with reference to the attached drawings, in which:
FIG. 1 is an illustrative block diagram for illustrating a non-volatile memory device according to some implementations;
FIG. 2 is an illustrative circuit diagram for illustrating a non-volatile memory device according to some implementations;
FIG. 3 is a schematic layout diagram for illustrating a semiconductor memory device according to some implementations;
FIG. 4 is a cross-sectional view taken along A-A' in FIG. 3;
FIG. 5 is an enlarged view for illustrating a P area of FIG. 4;
FIG. 6 is a diagram for illustrating a semiconductor memory device according to some implementations;
FIG. 7 is an enlarged view for illustrating a P area of FIG. 6;
FIG. 8 to FIG. 13 are diagrams for illustrating a semiconductor memory device according to some implementations;
FIGS. 14 to 23 are cross-sectional views of intermediate structures corresponding to intermediate steps for illustrating a method for manufacturing a semiconductor memory device according to some implementations;
FIGS. 24 to 27 are cross-sectional views of intermediate structures corresponding to intermediate steps for illustrating a method for manufacturing a semiconductor memory device according to some implementations;
FIGS. 28 to 34 are cross-sectional views of intermediate structures corresponding to intermediate steps for illustrating a method for manufacturing a semiconductor memory device according to some implementations;
FIG. 35 to FIG. 41 are cross-sectional views of intermediate structures corresponding to intermediate steps for illustrating a method for manufacturing a semiconductor memory device according to some implementations;
FIG. 42 is an illustrative block diagram for illustrating an electronic system according to some implementations;
FIG. 43 is an illustrative perspective view for illustrating an electronic system according to some implementations; and
FIG. 44 is a schematic cross-sectional view taken along I-I of FIG. 43.

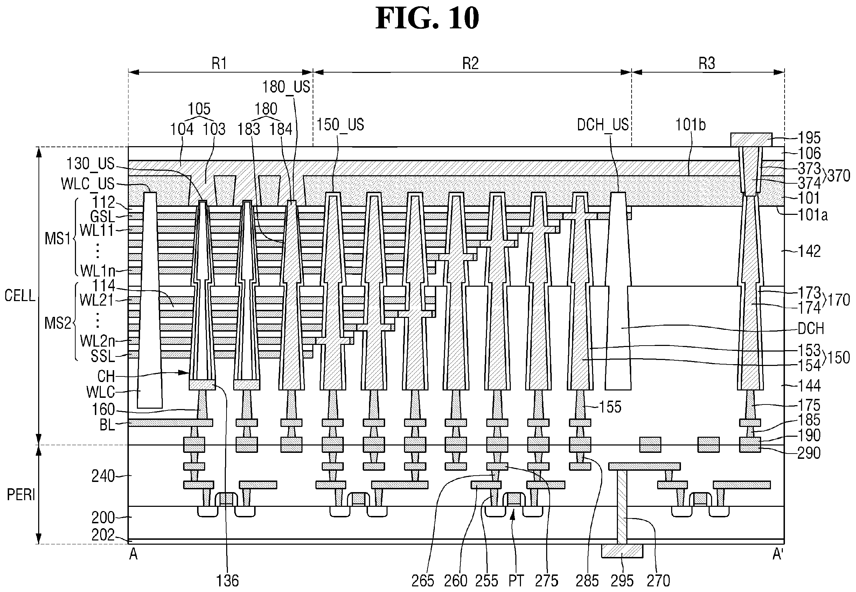

Figures 10, 25, 26, 27 are embodiments of the present invention; the other figures are examples useful for understanding the present invention.

### DETAILED DESCRIPTIONS

Hereinafter, implementations of the present disclosure will be described in detail with reference to the accompanying drawings. The same reference numerals are used for the same components in the drawings, and duplicate descriptions thereof are omitted.

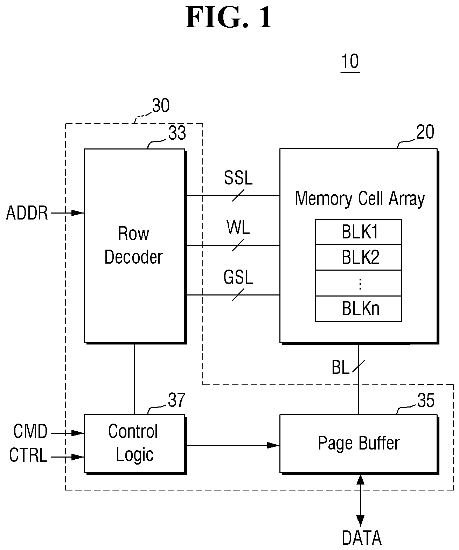

FIG. 1 is an illustrative block diagram for illustrating a non-volatile memory device according to some implementations.

Referring to FIG. 1, a semiconductor memory device 10 according to some implementations includes a memory cell array 20 and a peripheral circuit 30.

The memory cell array 20 may include a plurality of memory cell blocks BLK1 to BLKn. Each of the memory cell blocks BLK1 to BLKn may include a plurality of memory cells. The memory cell array 20 may be connected to the peripheral circuit 30 via a bit-line BL, word-lines WL11 to WL1n, and WL21 to WL2n, at least one string select line SSL, and at least one ground select line GSL. Specifically, the memory cell blocks BLK1 to BLKn may be connected to a row decoder 33 via the word-lines WL11 to WL1n, and WL21 to WL2n, the string select line SSL and the ground select line GSL. Further, the memory cell blocks BLK1 to BLKn may be connected to a page buffer 35 via the bit-line BL.

The peripheral circuit 30 may receive an address ADDR, a command CMD, and a control signal CTRL from an external device to the semiconductor memory device 10, and may transmit and receive data DATA to and from an external device to the semiconductor memory device 10. The peripheral circuit 30 may include a control logic 37, the row decoder 33, and the page buffer 35. Although not shown, the peripheral circuit 30 may further include various subcircuits such as an input/output circuit, a voltage generation circuit for generating various voltages for an operation of the semiconductor memory device 10, and an error correction circuit for correcting an error of the data DATA read from the memory cell array 20.

The control logic 37 may be connected to the row decoder 33, the input/output circuit, and the voltage generation circuit. The control logic 37 may control overall operations of the semiconductor memory device 10. The control logic 37 may generate various internal control signals used in the semiconductor memory device 10 in response to the control signal CTRL. For example, the control logic 37 may adjust a voltage level of a voltage supplied to the word-lines WL11 to WL1n, and WL21 to WL2n and the bit-line BL when performing a memory operation such as a program operation or an erase operation.

The row decoder 33 may select at least one of the plurality of memory cell blocks BLK1 to BLKn in response to the address ADDR, and may select at least one word-line WL1 1 to WL1n, and WL21 to WL2n, at least one string select line SSL, and at least one ground select line GSL of the selected at least one memory cell block BLK1 to BLKn. Further, the row decoder 33 may transmit a voltage for performing a memory operation to the word-line WL11 to WL1n, and WL21 to WL2n of the selected at least one memory cell block BLK1 to BLKn.

The page buffer 35 may be connected to the memory cell array 20 via the bit-line BL. The page buffer 35 may operate as a writer driver or a sense amplifier. Specifically, when performing a program operation, the page buffer 35 operates as the writer driver to apply a voltage based on the data DATA to be stored in the memory cell array 20 to the bit-line BL. On the other hand, when performing a read operation, the page buffer 35 may operate as the sense amplifier to detect the data DATA stored in the memory cell array 20.

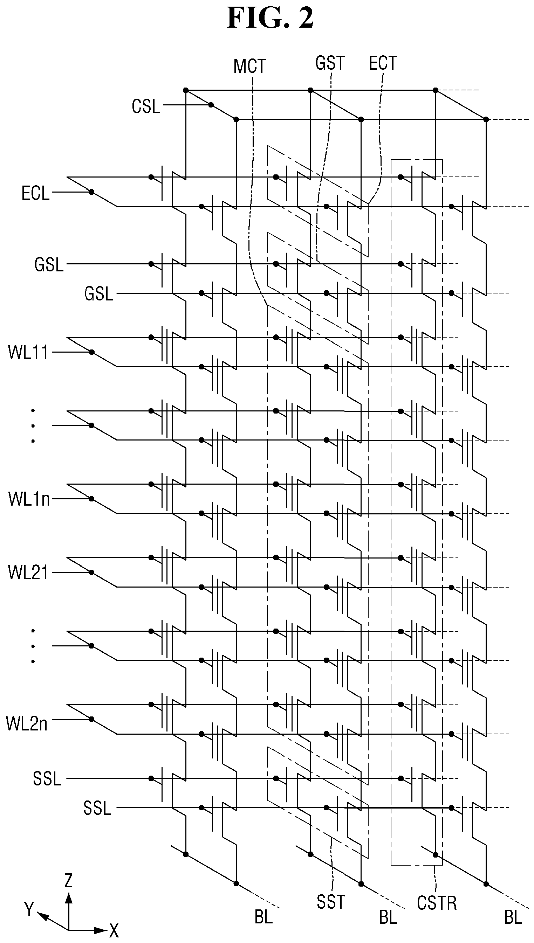

FIG. 2 is an illustrative circuit diagram for illustrating a non-volatile memory device according to some implementations.

Referring to FIG. 2, the memory cell array (20 in FIG. 1) of the non-volatile memory device according to some implementations includes a common source line CSL, a plurality of bit-lines B, and a plurality of cell strings CSTR.

The common source line CSL may extend in a first direction X. In some implementations, a plurality of common source lines CSL may be two-dimensionally arranged. For example, the plurality of common source lines CSL may be spaced apart from each other while extending in the first direction X. The same voltage may be electrically applied to the common source lines CSL. In some implementations, different voltages may be individually applied to be the common source lines CSL.

The plurality of bit-lines BL may be two-dimensionally arranged. For example, the bit-lines BL may be spaced apart from each other and extend in a second direction Y intersecting the first direction X. The plurality of cell strings CSTR may be connected in parallel to each of the bit-lines BL. The cell strings CSTR may be commonly connected to the common source line CSL. That is, the plurality of cell strings CSTR may be disposed between the bit-lines BL and the common source line CSL.

Each of the cell strings CSTR may include a ground select transistor GST connected to the common source line CSL, a string select transistor SST connected to the bit-line BL, and a plurality of memory cell transistors MCT disposed between the ground select transistor GST and the string select transistor SST. Each of the memory cell transistors MCT may include a data storage element. The ground select transistor GST, the string select transistor SST and the memory cell transistors MCT may be connected in series to each other in the third direction Z. In accordance with the present disclosure, the first direction X, the second direction Y, and the third direction Z may be substantially perpendicular to each other.

The common source line CSL may be commonly connected to sources of the ground select transistors GST. Further, a ground select line GSL, a plurality of word-lines WL11 to WL1n, and WL21 to WL2n, and a string select line SSL may be disposed between the common source line CSL and the bit-line BL. The ground select line GSL may act as a gate electrode of the ground select transistor GST. The word-lines WL11 to WL1n, and WL21 to WL2n may be respectively used as gate electrodes of the memory cell transistors MCT. The string select line SSL may act as a gate electrode of the string select transistor SST.

In some implementations, an erase control transistor ECT may be disposed between the common source line CSL and the ground select transistor GST and/or between the source select transistor SST and the bit-line BL. For example, the erase control transistor ECT may be connected to and disposed between the common source line CSL and the ground select transistor GST, while the common source line CSL may be commonly connected to sources of the erase control transistors ECT. Further, an erase control line ECL may be disposed between the common source line CSL and the ground select line GSL. The erase control line ECL may act as a gate electrode of the erase control transistor ECT. The erase control transistors ECT may generate gate induced drain leakage (GIDL) to execute an erase operation of the memory cell array.

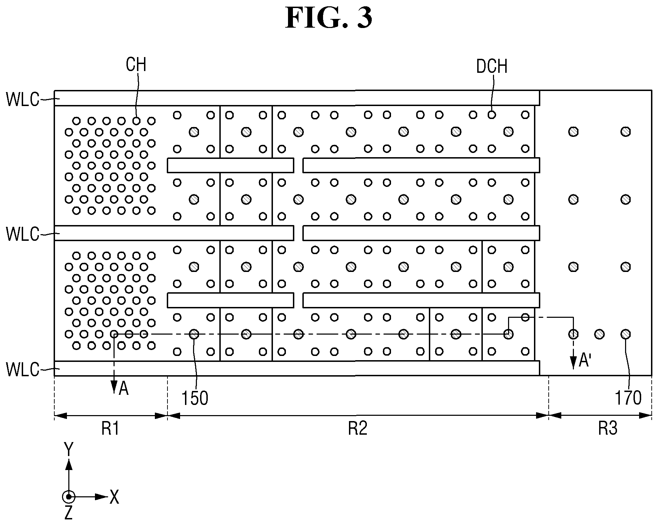

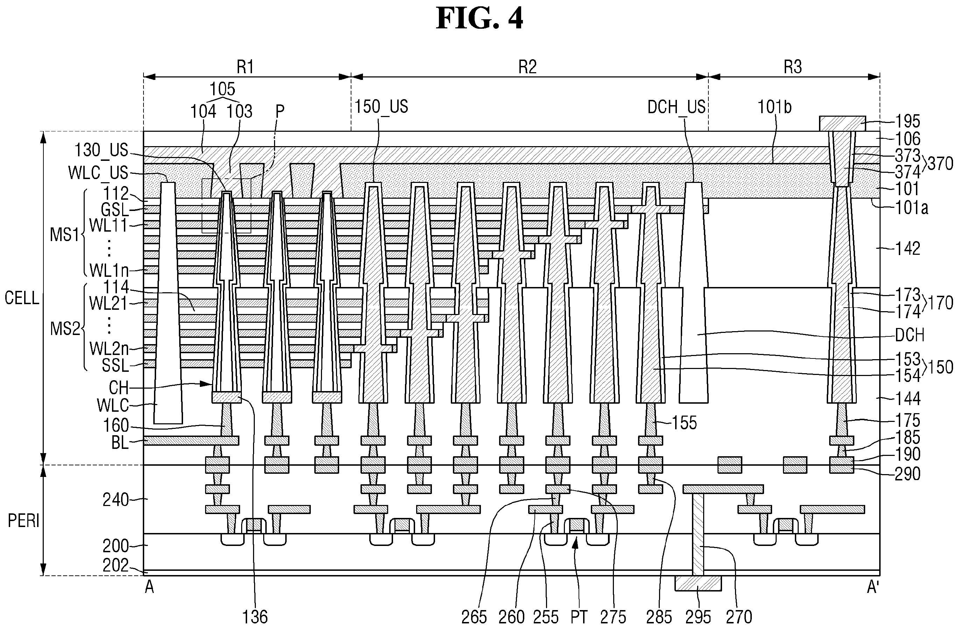

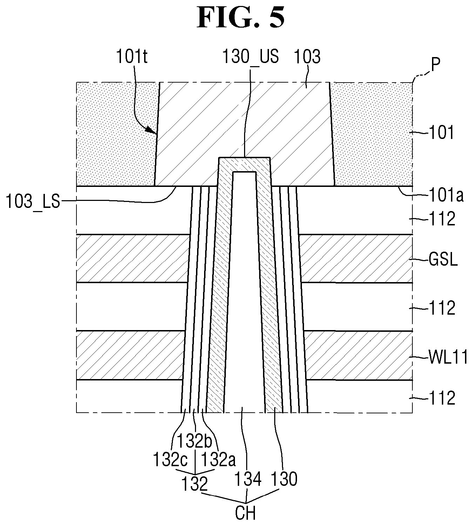

FIG. 3 is a schematic layout diagram for illustrating a semiconductor memory device according to some implementations. FIG. 4 is a cross-sectional view taken along A-A' in FIG. 3. FIG. 5 is an enlarged view to illustrate an area P of FIG. 4.

Referring to FIGS. 3 to 5, the semiconductor memory device according to some implementations may include a cell structure CELL and a peripheral circuit structure PERI on the cell structure CELL.

The cell structure CELL may include a semiconductor layer 101, a source structure 105, a first insulating layer 106, mold structures MS1 and MS2, interlayer insulating films 142 and 144, a channel structure CH, a dummy channel structure DCH, a word-line cutting structure WLC, a bit-line BL, a cell contact 150, an input/output contact 170, a first input/output pad 195, an input/output via 370, and a first bonding metal 190.

The semiconductor layer 101 may include a first face 101a and a second face 101b that are opposite to each other. In a third direction (Z of FIG. 3), the first face 101a may be a bottom face and the second face 101b may be a top face. In some implementations, the semiconductor layer 101 may include one of polysilicon doped with impurities and polysilicon that is not doped with impurities. The semiconductor layer 101 may be referred to as a base layer.

The semiconductor memory device may include first to third areas R1, R2, and R3.

The memory cell array (20 in FIG. 1) including a plurality of memory cells may be formed in the first area R1. For example, the channel structure CH, gate electrodes GSL, WL11 to WL1n, WL21 to WL2n, and SSL and the bit-line BL and the like, which will be described below, may be disposed in the first area R1. The memory cell array may be disposed on the first face 101a of the semiconductor layer 101.

The second area R2 may be defined around the first area R1. For example, the second area R2 may surround the first area R1 in a plan view. In the second area R2, the gate electrodes GSL, WL11 to WL1n, WL21 to WL2n, and SSL, which will be described below, may be stacked in a stepwise fashion. The cell contact 150 and the dummy channel structure DCH, which will be described below, may be disposed in the second area R2.

The third area R3 may be defined outside the second area R2. For example, the third area R3 may surround the second area R2 in a plan view. The input/output contact 170, which will be described below, may be disposed in the third area R3.

The source structure 105 may include a plug 103 and a plate 104.

The plug 103 may extend through the semiconductor layer 101. The semiconductor layer 101 may include a trench 101t extending from the first face 101a to the second face 101b. A width of the trench 101t may decrease as the trench extend away from the first face 101a. This may be due to characteristics of an etching process for forming trench 101t. The plug 103 may fill the trench 101t. Accordingly, a width of the plug 103 may decrease as the plug extends away from the first face 101a. The width of the plug 103 along the first face 101a of the semiconductor layer 101 may be equal to or greater than a width of the channel structure CH along the first face 101a of the semiconductor layer 101.

In some implementations, each trench 101t may be formed in a corresponding manner to each channel structure CH. The channel structures CH may be respectively disposed on the plugs 103 while being spaced apart from each other.

In some implementations, the source structure 105 may not contact the gate electrodes GSL, WL11 to WL1n, WL21 to WL2n, and SSL, e.g., may be electrically isolated from the gate electrodes. A bottommost face 103_LS of the plug 103 in the third direction Z may be coplanar with the first face 101a of the semiconductor layer 101.

The plate 104 may be connected to the plug 103 and disposed on the second face 101b of the semiconductor layer 101. The plate 104 may extend along the second face 101b of the semiconductor layer 101. In some implementations, the plate 104 may be disposed along the first to third areas R1, R2, and R3. The plate 104 may cover the second face 101b of the semiconductor layer 101.In some implementations, the plate 104 may be disposed only in the first area R1, or the plate 104 may be disposed in the first area R1 and the second area R2.

The first insulating layer 106 may be disposed on the source structure 105. The first insulating layer 106 may be disposed on the plate 104 of the source structure 105

The mold structures MS1 and MS2 may be disposed on the first face 101a of the semiconductor layer 101. The mold structures MS1 and MS2 may include a plurality of gate electrodes GSL, WL11 to WL1n, WL21 to WL2n, and SSL and a plurality of mold insulating films 112 and 114 stacked on the semiconductor layer 101. Each of the gate electrodes GSL, WL11 to WL1n, WL21 to WL2n, and SSL and each of the mold insulating films 112 and 114 may have a layer-like structure extending in a parallel manner to the first face 101a of the semiconductor layer 101. The gate electrodes GSL, WL11 to WL1n, WL21 to WL2n, and SSL may be sequentially stacked on the semiconductor layer 101 while being spaced apart from each other via the mold insulating films 112 and 114. In some implementations, the erase control line ECL may be omitted, and the gate electrode GSL among the gate electrodes GSL, WL11 to WL1n, WL21 to WL2n, and SSL may be closest to the first face 101a of the semiconductor layer 101.

In some implementations, the mold structures MS1 and MS2 may include the first mold structure MS1 and the second mold structure MS2 that are sequentially stacked on the semiconductor layer 101.

The first mold structure MS1 may include the first gate electrodes GSL, and WL11 to WL1n, and the first mold insulating films 112 alternately stacked on top of each other while being disposed on the first face 101a of the semiconductor layer 101. In some implementations, the first gate electrodes GSL, and WL11 to WL1n may include the ground select line GSL and the plurality of first word-lines WL11 to WL1n sequentially stacked on the semiconductor layer 101. The number and arrangement of the ground select line GSL and the first word-lines WL11 to WL1n are merely examples and are not limited thereto.

The second mold structure MS2 may include the second gate electrodes WL21 to WL2n, and SSL and the second mold insulating films 114 alternately stacked on top of each other while being disposed on the first mold structure MS1. In some implementations, the second gate electrodes WL21 to WL2n and SSL may include the plurality of second word-lines WL21 to WL2n and the string select line SSL sequentially stacked on the first mold structure MS1. The number and arrangement of the second word-lines WL21 to WL2n and the string select line SSL are merely examples and are not limited thereto.

Each of the gate electrode GSL, WL11 to WL1n, WL21 to WL2n, and SSL may include a conductive material, for example, a metal such as tungsten (W), cobalt (Co), nickel (Ni), or a semiconductor material such as silicon. However, the present disclosure is not limited thereto.

Each of the mold insulating films 112 and 114 may include an insulating material, for example, at least one of silicon oxide, silicon nitride, or silicon oxynitride. However, the present disclosure is not limited thereto.

The interlayer insulating films 142 and 144 may be formed on the first face 101a of the semiconductor layer 101 so as to respectively cover the mold structures MS1 and MS2. In some implementations, the interlayer insulating films 142 and 144 may include the first interlayer insulating film 142 and the second interlayer insulating film 144 sequentially stacked on the semiconductor layer 101. The first interlayer insulating film 142 may cover the first mold structure MS1, and the second interlayer insulating film 144 may cover the second mold structure MS2. Each of the interlayer insulating films 142 and 144 may include, for example, at least one of silicon oxide, silicon oxynitride, or a low-k material having a lower dielectric constant than that of silicon oxide. However, the present disclosure is not limited thereto.

The channel structure CH may be disposed on the first face 101a of the semiconductor layer 101 and in the first area R1. The channel structure CH may extend in a vertical direction (hereinafter, the third direction Z) that intersects the first face 101a of the semiconductor layer 101 and may extend through the mold structures MS1 and MS2. For example, the channel structure CH may have a pillar shape (for example, a cylindrical shape) extending in the third direction Z. Accordingly, the channel structure CH may intersect the plurality of gate electrodes GSL, WL11 to WL1n, WL21 to WL2n, and SSL.

The channel structure CH may include a portion whose a width decreases as the portion extends toward the first face 101a of the semiconductor layer 101. In some implementations, the channel structure CH may have a bent portion between the first mold structure MS1 and the second mold structure MS2, e.g., a portion in which one or more layers of the channel structure CH extend horizontally, in a direction parallel to the first face 101a of the semiconductor layer 101. The channel structure CH may have a first portion in the first mold structure MS1 whose width decreases as the first portion extends toward the first face 101a of the semiconductor layer 101, and/or may have a second portion in the second mold structure MS2 whose a width decreases as the second portion extends toward the first face 101a of the semiconductor layer 101. This may be due to characteristics of an etching process to form the channel structure CH.

The channel structure CH may include a channel film 130 and an information storage film 132.

The channel film 130 may extend in the third direction Z and extend through the mold structures MS1 and MS2. Although it is illustrated that the channel film 130 has a shape of a cup (e.g., a tapered or non-tapered shape defining the exterior of an inner region), this is only an example. For example, the channel film 130 may have various shapes, such as a cylindrical shape, a rectangular cylindrical shape, and a solid pillar shape. The channel film 130 may include, but is not limited to, a semiconductor material such as single crystal silicon, polycrystalline silicon, organic semiconductor, and carbon nanostructure. The channel film 130 may act as a channel of a transistor (for example, the erase control transistor ECT, the ground select transistor GST, the memory cell transistor MCT, and the string select transistor SST in FIG. 2) constituting the memory cell array (20 in FIG. 1 and FIG. 2).

In some implementations, a portion of the channel structure CH may be disposed within the trench 101t of the semiconductor layer 101. The channel structure CH may be disposed on the plug 103 of the source structure 105. The channel structure CH may extend through a portion of the plug 103. For example, one end of the channel film 130 may be embedded in the plug 103. The topmost face of the channel structure CH in the third direction Z may be a top face 130_US of the channel film 130 in the third direction Z. The top face 130_US of the channel film 130 in the third direction Z may be disposed in the plug 103. The top face 130_US of the channel film 130 may be disposed between the first face 101a and the second face 101b of the semiconductor layer 101. The top face 130_US of the channel film 130 and at least a portion of a side face of the channel film 130 may contact the plug 103. The arrangement of the channel film 130 may improve contact with the plug 103 (e.g., provide increased contact area) to reduce a contact resistance.

In some implementations, a vertical level of the topmost face 130_US of the channel structure CH may be different from that of one, some, or all of a top face DCH_US in the third direction Z of the dummy channel structure DCH, a top face 150_US in the third direction Z of the cell contact 150, and a top face WLC_US of the word-line cutting structure WLC. In the third direction Z, the vertical level of the topmost face 130_US of the channel structure CH may be lower than that of one, some, or all of the top face DCH_US of the dummy channel structure DCH, the top face 150_US of the cell contact 150, and the top face WLC_US of the word-line cutting structure WLC. The topmost face 130_US of the channel structure CH may be closer to the first face 101a of the semiconductor layer 101 than one, some, or all of the top face DCH_US of the dummy channel structure DCH, the top face 150_US of the cell contact 150, and the top face WLC_US of the word-line cutting structure WLC may be. In one example, the top face DCH_US of the dummy channel structure DCH, the top face 150_US of the cell contact 150, and the top face WLC _US of the word-line cutting structure WLC may be substantially coplanar with each other. However, the present disclosure is not limited thereto.

The information storage film 132 may be interposed between the channel film 130 and each of the gate electrodes GSL, WL11 to WL1n, WL21 to WL2n, and SSL. For example, the information storage film 132 may extend along an outer face of the channel film 130. In some implementations, a top face of the information storage film 132 in the third direction Z may be coplanar with the first face 101a of the semiconductor layer 101.

The information storage film 132 may include, for example, at least one of silicon oxide, silicon nitride, silicon oxynitride, or a high dielectric constant (high-k) material having a higher dielectric constant than that of silicon oxide. The high dielectric constant material may include, for example, at least one of aluminum oxide, hafnium oxide, lanthanum oxide, tantalum oxide, titanium oxide, lanthanum hafnium oxide, lanthanum aluminum oxide, dysprosium scandium oxide, or combinations thereof.

In some implementations, the information storage film 132 may be embodied as a multilayer. For example, the information storage film 132 may include a tunnel insulating film 132a, a charge storage film 132b, and a blocking insulating film 132c that are sequentially stacked on an outer side face of the channel film 130.

The tunnel insulating film 132a may include, for example, silicon oxide or a high dielectric constant material (for example, aluminum oxide (Al₂O₃) or hafnium oxide (HfO₂)) having a higher dielectric constant than that of silicon oxide. The charge storage film 132b may include, for example, silicon nitride. The blocking insulating film 132c may include, for example, silicon oxide or a high dielectric constant material (for example, aluminum oxide (Al₂O₃) or hafnium oxide (HfO₂)) having a higher dielectric constant than that of silicon oxide.

In some implementations, the channel structure CH may further include a filling pattern 134. The filling pattern 134 may be formed to fill an inner space defined by the cup-shaped channel film 130. The filling pattern 134 may include an insulating material, for example, silicon oxide. However, the present disclosure is not limited thereto.

In some implementations, the channel structure CH may further include a channel pad 136. The channel pad 136 may be formed to be connected to the other end of the channel film 130. The channel pad 136 may include, for example, polysilicon doped with impurities. However, the present disclosure is not limited thereto.

In some implementations, the plurality of channel structures CH may be arranged in a zigzag manner. For example, the plurality of channel structures CH may be arranged in a staggered manner in each of the first direction X and the second direction Y. The plurality of channel structures CH arranged in the zigzag manner may improve integration of the semiconductor memory device. The number and arrangement of the channel structures CH are merely examples, and are not limited thereto. In some implementations, the channel structures CH may be arranged in a form of a honeycomb.

The dummy channel structure DCH may extend in the third direction Z and extend through the interlayer insulating films 142 and 144 and the mold structures MS1 and MS2. Unlike the channel structure CH, the dummy channel structure DCH does not function as a channel of a transistor. For example, the dummy channel structure DCH may not be connected to the bit-line BL to be described below. The dummy channel structure DCH may be formed in a similar form to that of the channel structure CH, so that stress applied to the mold structures MS1 and MS2 may be reduced in the second area R2. The dummy channel structure DCH may serve as a pillar (for example, a support) that physically supports the gate electrodes GSL, WL1 to WLn, WL2 to WL2n, and SSL stacked in a stepped manner. The dummy channel structure DCH may include, for example, an insulating material. In some implementations, the dummy channel structure DCH may include the same film as that of the channel structure CH, but may not be connected to the bit-line BL.

In some implementations, the top face DCH_US of the dummy channel structure DCH may be disposed in the semiconductor layer 101. The top face DCH_US of the dummy channel structure DCH may be disposed between the first face 101a and the second face 101b of the semiconductor layer 101.

The word-line cutting structures WLC may be two-dimensionally arranged in a plane defined by the first direction X and the second direction Y. For example, the word-line cutting structures WLC may extend in the first direction X and may be arranged and spaced apart from each other along the second direction Y.

The word-line cutting structure WLC may be disposed on the semiconductor layer 101. The word-line cutting structure WLC may be spaced apart from the plate 104 of the source structure 105 via the semiconductor layer 101. In some implementations, the top face WLC_US of the word-line cutting structure WLC may be disposed in the semiconductor layer 101. The top face WLC_US of the word-line cutting structure WLC may be disposed between the first face 101a and the second face 101b of the semiconductor layer 101.

Each of the mold structures MS1 and MS2 may be divided into a plurality of memory cell blocks via the word-line cutting structures WLC. For example, the word-line cutting structures WLC may electrically isolate portions of the mold structures MS1 and MS2 from other portions of the mold structures MS1 and MS2 to define the plurality of memory cell blocks. The word-line cutting structure WLC may include, but is not limited to, an insulating material, for example, at least one of silicon oxide, silicon nitride, or silicon oxynitride.

The bit-line BL may be formed on the mold structures MS1 and MS2. The bit-line BL may intersect the word-line cutting structure WLC. For example, the bit-lines BL may extend in the second direction Y, and may be arranged and spaced apart from each other in the first direction X.

The bit-line BL may be connected to a plurality of channel structures CH arranged along the second direction Y. For example, a bit-line contact 160 connected to the channel pad 136 may be disposed in the second interlayer insulating film 144. The bit-line BL may be electrically connected to the channel structures CH via the bit-line contact 160.

The cell contact 150 may be disposed on the semiconductor layer 101. The cell contact 150 may be spaced apart from the plate 104 of the source structure 105 via the semiconductor layer 101. The cell contact 150 may extend in the third direction Z and extend through the interlayer insulating films 142 and 144 and the mold structures MS1 and MS2. The cell contact 150 may include a portion whose a width decreases as the portion extends toward the first face 101a of the semiconductor layer 101. In some implementations, the cell contact 150 may have a bent portion between the first mold structure MS1 and the second mold structure MS2. The cell contact 150 may have a first portion in the first mold structure MS1 whose width decreases as the first portion extends toward the first face 101a of the semiconductor layer 101, and a second portion in the second mold structure MS2 whose width decreases as the second portion extends toward the first face 101a of the semiconductor layer 101. This may be due to characteristics of an etching process for forming the cell contact 150.

In some implementations, the top face 150_US of the cell contact 150 may be disposed in the semiconductor layer 101. The top face 150_US of the cell contact 150 may be disposed between the first face 101a and the second face 101b of the semiconductor layer 101.

The cell contact 150 may be electrically connected to one, some, or all of the gate electrodes ECL, GSL, WL1 to WLn, and SSL in the second area R2. The cell contact 150 may be in contact with the lowermost gate electrode in the third direction Z among the gate electrodes GSL, WL1 to WLn, WL2 to WL2n, and SSL stacked in the stepped manner. For example, the cell contact 150 may be in contact with a sidewall of the lowermost gate electrode. The gate electrode SSL as the lowermost layer of the mold structures MS1 and MS2 may be in contact with the second interlayer insulating film 144.

The cell contact 150 may include multiple cell contacts 150, each cell contact 150 electrically connected to at least one of the gate electrodes ECL, GSL, WL1 to WLN, and SSL. For example, each cell contact 150 may be electrically connected to a respective one of the gate electrodes by providing an absence of a first spacer film 153 at a different respective height in the mold structures MS1 and MS2, the different respective heights corresponding to different gate electrodes.

The cell contact 150 may include the first spacer film 153 and a first filling film 154. The first filling film 154 may extend through the interlayer insulating films 142 and 144 and the mold structures MS1 and MS2. The first spacer film 153 may extend along a side face of the first filling film 154 and a top face thereof in the third direction Z. The first spacer film 153 may not be interposed between portions of the gate electrodes GSL, WL1 to WLn, WL2 to WL2n, and SSL and the cell contact 150 in contact with each other, to allow for conduction between the gate electrodes and the cell contact 150. For example, the first spacer film 153 may include an insulating material, while the first filling film 154 may include a conductive material.

In some implementations, a portion of the cell contact 150 in contact with the gate electrodes GSL, WL1 to WLn, WL2 to WL2n, and SSL may protrude from a sidewall of the cell contact 150. A thickness of a sidewall of a portion of the gate electrode in contact with the cell contact 150 may be greater than a thickness of a sidewall of a portion of the gate electrode not in contact with the cell contact 150. However, the technical scope of the present disclosure is not limited thereto.

The cell contact 150 may be electrically connected to the bit-line BL via a first contact 155. The first contact 155 may include a conductive material. The first contact 155 may include, for example, tungsten (W) or copper (Cu). However, the present disclosure is not limited thereto.

The input/output contact 170 may be disposed on the semiconductor layer 101. The input/output contact 170 may be spaced apart from the plate 104 of the source structure 105 via the semiconductor layer 101. The input/output contact 170 may extend in the third direction Z and may extend through the interlayer insulating films 142 and 144 so as to be electrically connected to the first input/output pad 195 to be described below. The input/output contact 170 may include a portion whose a width decreases as the portion extends toward the first face 101a of the semiconductor layer 101. In some implementations, the input/output contact 170 may have a bent portion between the first mold structure MS1 and the second mold structure MS2. The input/output contact 170 may have a first portion in the first mold structure MS1 whose width decreases as the first portion extends toward the first face 101a of the semiconductor layer 101, and a second portion in the second mold structure MS2 whose width decreases as the second portion extends toward the first face 101a of the semiconductor layer 101. This may be due to characteristics of an etching process for forming the input/output contact 170.

The input/output contact 170 may include a second spacer film 173 and a second filling film 174. The second filling film 174 may extend through the interlayer insulating films 142 and 144 and the mold structures MS1 and MS2. The second spacer film 173 may extend along a side face of the second filling film 174 and a top face thereof in the third direction Z. For example, the second spacer film 173 may include an insulating material, and the second filling film 174 may include a conductive material.

The input/output contact 170 may be electrically connected to the bit-line BL via a second contact 175. The second contact 175 may include a conductive material. The second contact 175 may include, for example, tungsten (W) or copper (Cu). However, the present disclosure is not limited thereto.

The first input/output pad 195 may be formed on the second face 101b of the semiconductor layer 101. For example, the first input/output pad 195 formed on the second face 101b of the semiconductor layer 101 may be disposed on the first insulating layer 106 covering the source structure 105. The first input/output pad 195 may be electrically connected to the input/output contact 170 via the input/output via 370. The first input/output pad 195 may be electrically connected to the peripheral circuit structure PERI via the input/output via 370 and the input/output contact 170. The first input/output pad 195 may electrically connect an external device and the semiconductor memory device to each other. The first input/output pad 195 may include, but is not limited to, aluminum (Al).

In some implementations, the input/output via 370 may extend through the first insulating layer 106, the plate 104 of the source structure 105 and the semiconductor layer 101. A width of the input/output via 370 may, for example, decrease as the input/output via 370 extends toward the first face 101a of the semiconductor layer 101. The input/output via 370 may include a third spacer film 373 and a third filling film 374. The third spacer film 373 may extend along a side face of the third filling film 374. The third filling film 374 may contact the second filling film 174. The third filling film 374 may be spaced from the source structure 105 via the third spacer film 373. For example, the third filling film 374 may extend through a portion of the second filling film 174. However, the present disclosure is not limited thereto. For example, the second spacer film 173 may include an insulating material, and the third filling film 374 may include a conductive material.

The peripheral circuit structure PERI may include a peripheral circuit substrate 200, a peripheral circuit element PT, a second insulating layer 202, a third interlayer insulating film 240, a plurality of wiring patterns 260 and 275, a plurality of wiring contacts 255 and 265, and a second bonding metal 290.

The peripheral circuit substrate 200 may include, for example, a semiconductor substrate such as a silicon substrate, a germanium substrate, or a silicon-germanium substrate. In some implementations, the peripheral circuit substrate 200 may be embodied as a silicon-on-insulator (SOI) substrate or a germanium-on-insulator (GOI) substrate, etc.

The peripheral circuit element PT may be formed on the peripheral circuit substrate 200. The peripheral circuit element PT may constitute a peripheral circuit (for example, 30 in FIG. 1) that controls an operation of the semiconductor memory device. For example, the peripheral circuit element PT may include the control logic (for example, 37 in FIG. 1), the row decoder (for example, 33 in FIG. 1), and the page buffer (for example, 35 in FIG. 1), and/or the like. In following description, a surface of the peripheral circuit substrate 200 on which the peripheral circuit element PT is disposed may be referred to as a front face of the peripheral circuit substrate 200. Conversely, a face of the peripheral circuit substrate 200 opposite to the front face of the peripheral circuit substrate 200 may be referred to as a rear face of the peripheral circuit substrate 200.

The peripheral circuit element PT may include, for example, a transistor. However, the present disclosure is not limited thereto. For example, the peripheral circuit element PT may include not only various active elements such as a transistor, but also various passive elements such as a capacitor, a resistor, and an inductor.

The second insulating layer 202 may be disposed on the rear face of the peripheral circuit substrate 200. The second input/output pad 295 may be disposed on the second insulating layer 202. The second input/output pad 295 may be connected to at least one of the peripheral circuit elements PT disposed in the peripheral circuit structure PERI via a second input/output contact 270. The peripheral circuit substrate 200 and the second input/output pad 295 may be spaced from each other via the second insulating layer 202.

The third interlayer insulating film 240 may be disposed on the front face of the peripheral circuit substrate 200. The plurality of wiring patterns 260 and 275 and the plurality of wiring contacts 255 and 265 may be disposed in the third interlayer insulating film 240. The third interlayer insulating film 240 may include an insulating material. For example, the third interlayer insulating film 240 may include at least one of silicon oxide, silicon oxynitride, or a low-k material having a lower dielectric constant than that of silicon oxide. However, the present disclosure is not limited thereto.

The plurality of wiring patterns 260 and 275 and the plurality of wiring contacts 255 and 265 may be electrically connected to each other. The peripheral circuit element PT and the bit-lines BL may be electrically connected to each other via the plurality of wiring patterns 260 and 275 and the plurality of wiring contacts 255 and 265. Each of the plurality of wiring patterns 260 and 275 and the plurality of wiring contacts 255 and 265 may include a conductive material. Each of the plurality of wiring patterns 260 and 275 and the plurality of wiring contacts 255 and 265 may include, but is not limited to, tungsten (W) or copper (Cu).

The semiconductor memory device according to some implementations may have a C2C (chip-to-chip) structure. The C2C structure may be formed by manufacturing an upper chip including a first wafer and the cell structure CELL on the first wafer, and then manufacturing a lower chip including a second wafer different from the first wafer and the peripheral circuit structure PERI on the second wafer, and then coupling the upper chip and the lower chip to each other in a bonding scheme.

In one example, the bonding scheme may refer to a scheme of electrically connecting the first bonding metal 190 as the uppermost metal layer (in a direction from the second face 101b of the semiconductor layer 101 toward the first face 101b thereof) of the upper chip and the second bonding metal 290 as the uppermost metal layer (in a direction from the front face to the rear face of the peripheral circuit substrate 200) of the lower chip to each other. For example, when each of the first and second bonding metals 190 and 290 is made of copper (Cu), the bonding scheme may be a Cu-Cu bonding scheme. In some implementations, each of the first and second bonding metals 190 and 290 may be made of aluminum (Al) or tungsten (W).

The first bonding metal 190 may be connected to the bit-line BL via a first bonding contact 185. The second bonding metal 290 may be connected to the peripheral circuit elements PT via a second bonding contact 285. Thus, the peripheral circuit structure PERI and the cell structure CELL may be electrically connected to each other.

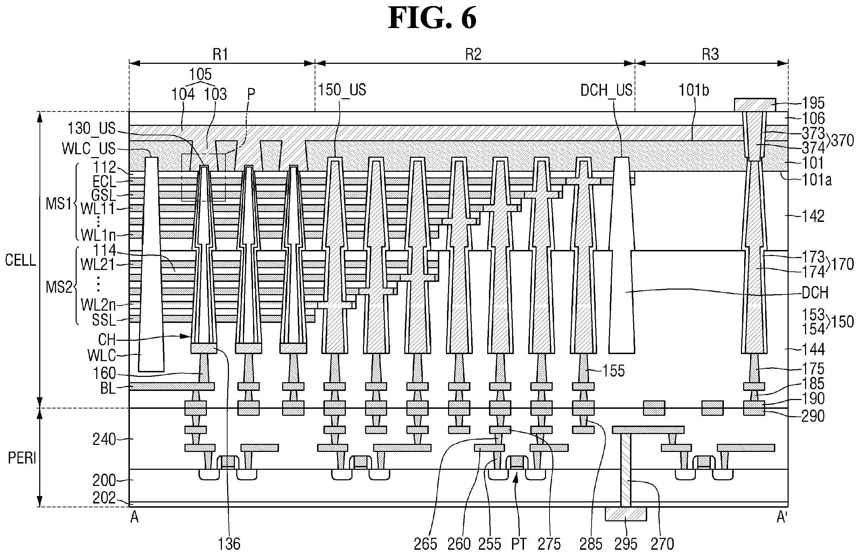

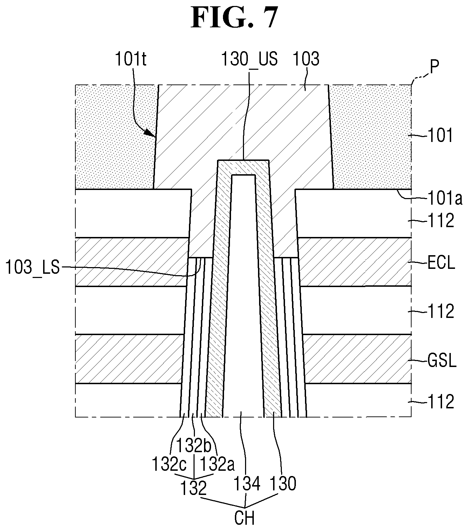

FIG. 6 is a diagram for illustrating a semiconductor memory device according to some implementations. FIG. 7 is an enlarged view to illustrate an area P of FIG. 6. For reference, FIG. 6 is a cross-sectional view taken along A-A' in FIG. 3. For convenience of description, following descriptions are based on differences thereof from those as set forth with reference to FIGS. 1 to 5.

Referring to FIGS. 6 and 7, in the semiconductor memory device according to some implementations, the gate electrode ECL among the gate electrodes ECL, GSL, WL11 to WL1n, WL21 to WL2n, and SSL may be closest to the first face 101a of the semiconductor layer 101.

The source structure 105 may be in contact with the gate electrode ECL and may not contact the gate electrode GSL. The source structure 105 may be electrically connected to the gate electrode ECL. For example, the plug 103 may extend to the gate electrode ECL closest to the source structure 105 among the gate electrodes. The plug 103 may extend from the first face 101a of the semiconductor layer 101 into the information storage film 132. At least a portion of the plug 103 may overlap, for example, the gate electrode ECL in a direction parallel to the first face 101a of the semiconductor layer 101. A third face of the gate electrode ECL facing the first face 101a of the semiconductor layer 101 may be closer to the first face 101a of the semiconductor layer 101 than a bottommost face 103_LS of the plug 103 may be.

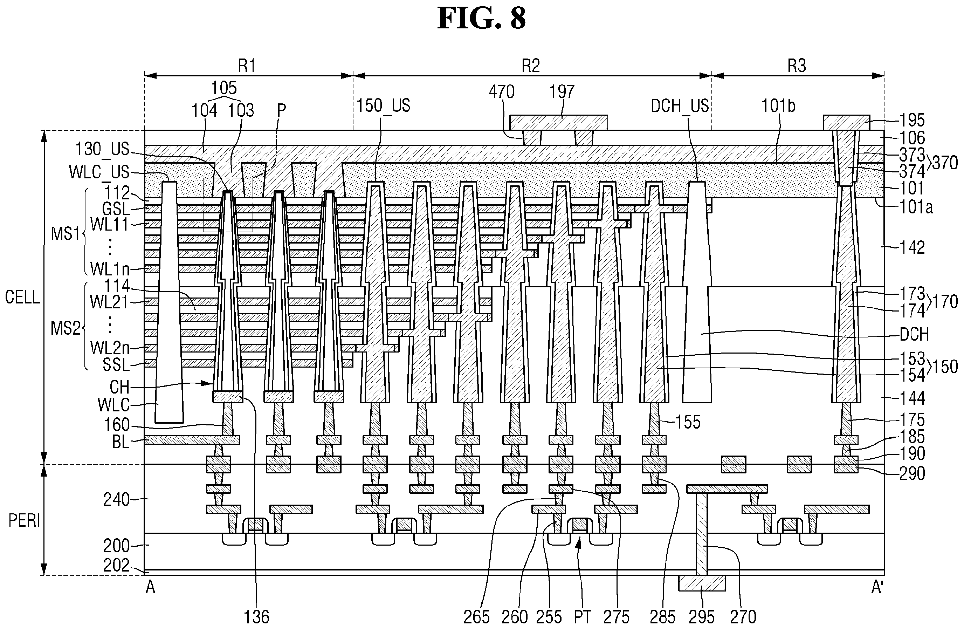

FIGS. 8 to 13 are diagrams for illustrating a semiconductor memory device according to some implementations. For reference, FIGS. 8 to 13 are cross-sectional views taken along A-A' in FIG. 3. For convenience of description, the following descriptions are based on differences thereof from those as set forth with reference to FIGS. 1 to 5.

Referring to FIG. 8, the semiconductor memory device according to some implementations may further include a wiring 197 and a wiring via 470. The wiring 197 may be disposed on the first insulating layer 106 while the wiring via 470 may be disposed in the first insulating layer 106. The number and arrangement of the wiring 197 and the wiring via 470 are merely examples and are not limited thereto. The wiring 197 may be formed at the same vertical level as, for example, a vertical level of the first input/output pad 195. For example, a width of the wiring via 470 may decrease as the wiring via 470 extends toward the source structure 105.

The wiring 197 may be electrically connected to source structure 105 via the wiring via 470. The wiring via 470 may extend through the first insulating layer 106 so as to contact the source structure 105 and the wiring 197. That is, the wiring 197 and the wiring via 470 may function as a source contact. Each of the wiring 197 and the wiring via 470 may include a conductive material. The wiring via 470 electrically connected to the source structure 105 is illustrated as being disposed in the second area R2. However, the present disclosure is not limited thereto. The wiring via 470 may be disposed in the first area R1 or the third area R3.

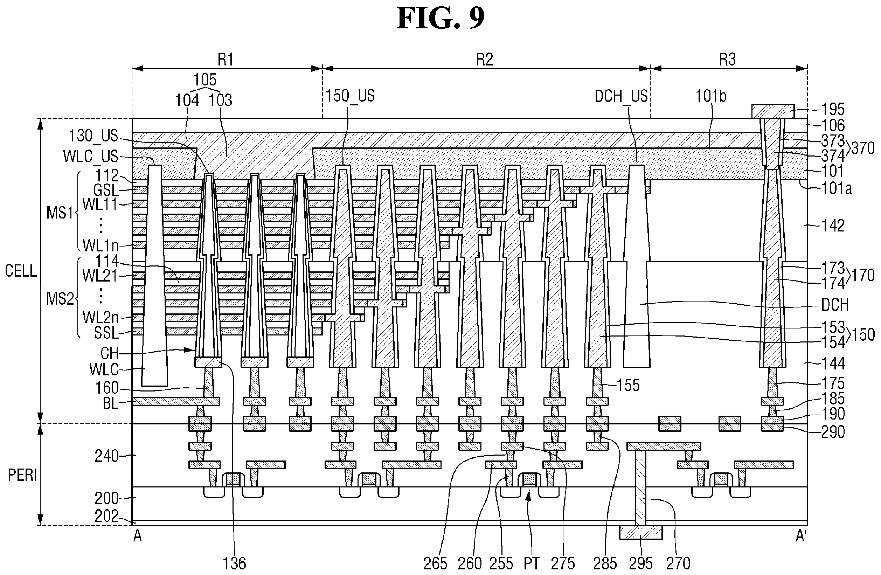

Referring to FIG. 9, in the semiconductor memory device according to some implementations, a plurality of channel structures CH may be disposed on one plug 103. For example, referring to FIG. 3, one plug 103 may be disposed between word-line cutting structures WLC adjacent to each other in the second direction Y. That is, the plurality of channel structures CH disposed between the word-line cutting structures WLC adjacent to each other in the second direction Y may be disposed on one plug 103. In some implementations, at least one plug 103 having various sizes or shapes on a plane defined by the first direction X and the second direction Y may be disposed between the word-line cutting structures WLC adjacent to each other in the second direction Y.

Referring to FIG. 10, the semiconductor memory device according to some implementations may further include a source contact 180. The source contact 180 may be disposed on the plug 103. The source contact 180 may extend in the third direction Z and may extend through the interlayer insulating films 142 and 144 so as to be electrically connected to the source structure 105. The source contact 180 may include a portion whose width decreases as the portion extends toward the first face 101a of the semiconductor layer 101. In some implementations, the source contact 180 may have a bent portion between the first mold structure MS1 and the second mold structure MS2. The source contact 180 may have a first portion in the first mold structure MS1 whose width decreases as the first portion extends toward the first face 101a of the semiconductor layer 101, and a second portion in the second mold structure MS2 whose width decreases as the second portion extends toward the first face 101a of the semiconductor layer 101. This may be due to characteristics of an etching process for forming the source contact 180. Although the source contact 180 is illustrated as being disposed in the first area R1, the source contact 180 may be disposed in the second area R2 or the third area R3.

The source contact 180 may include a fourth spacer film 183 and a fourth filling film 184. The fourth filling film 184 may extend through the interlayer insulating films 142 and 144 and the mold structures MS1 and MS2. The fourth filling film 184 may extend through a portion of the plug 103. For example, one end of the fourth filling film 184 may be embedded in the plug 103. The topmost face 180_US of the source contact 180 in the third direction Z may be a top face of the fourth filling film 184 in the third direction Z, and the topmost face 180_US of the source contact 180 may be disposed in the plug 103. The topmost face 180_US of the source contact 180 may be disposed between the first face 101a and the second face 101b of the semiconductor layer 101. The topmost face 180_US of the source contact 180 and at least a portion of a side face of the source contact 180 may contact the plug 103. The topmost face 180_US of the source contact 180 may be closer to the first face 101a of the semiconductor layer 101 than one or both of the top face WLC_US of the word-line cutting structure WLC and the top face 150_US of the cell contact 150 may be.

The fourth spacer film 183 may extend along a portion of a side face of the fourth filling film 184. The fourth spacer film 183 may not extend into the plug 103. That is, the fourth spacer film 183 may not be disposed between the plug 103 and the fourth filling film 184. For example, the fourth spacer film 183 may include an insulating material, and the fourth filling film 184 may include a conductive material. The fourth filling film 184 may be spaced from the gate electrodes GSL, WL11 to WL1n, WL21 to WL2n, and SSL via the fourth spacer film 183.

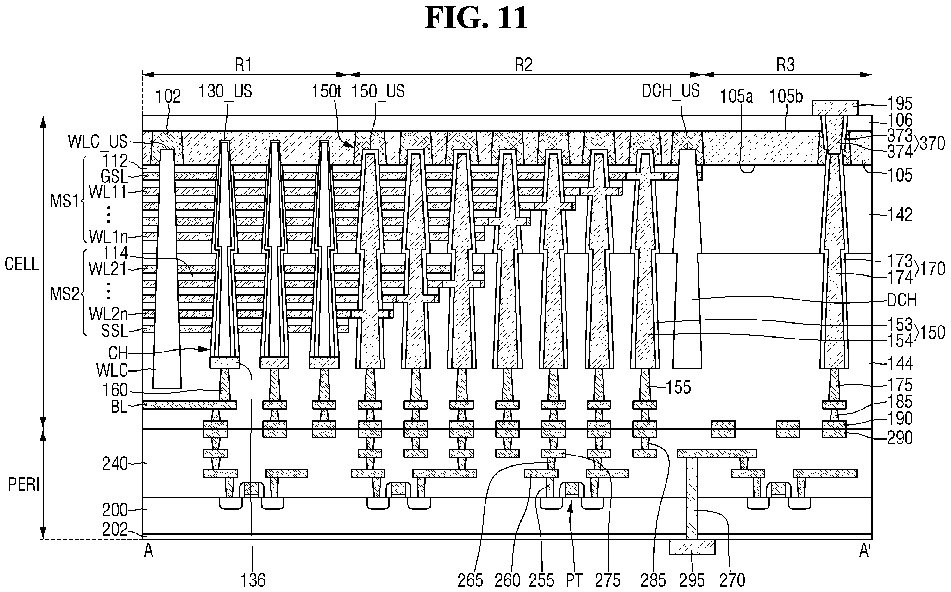

Referring to FIG. 11, in the semiconductor memory device according to some implementations, the source structure 105 may include a third face 105a and a fourth face 105b that are opposite to each other. The memory cell array may be disposed on the third face 105a of the source structure 105. The mold structures MS1 and MS2 may be disposed on the third face 105a of the source structure 105. The first insulating layer 106 may be disposed on the fourth face 105b of the source structure 105.

The source structure 105 may include a trench 105t extending from the third face 105a to the fourth face 105b. For example, a width of the trench 105t may decrease as the trench 105t extends in a direction from the third face 105a toward the fourth face 105b. An etch stop film 102 may fill the trench 105t. Accordingly, a width of the etch stop film 102 may decrease as the etch stop film 102 extends in a direction from the third face 105a toward the fourth face 105b.

The etch stop film 102 may include, for example, at least one of aluminum oxide (AlO), titanium nitride (TiN), tungsten nitride (WN), silicon carbonitride (SiCN), or impurity-doped polysilicon. The impurity-doped polysilicon may contain, for example, carbon (C) as the impurity. The etch stop film 102 may be referred to as a base layer.

The trench 105t may expose the top face WLC_US of the word-line cutting structure WLC, the top face 150_US of the cell contact 150, the top face DCH_US of the dummy channel structure DCH, and at least a portion of a top face of the input/output contact 170. The word-line cutting structure WLC, the cell contact 150, the dummy channel structure DCH, and the input/output contact 170 may be disposed on the etch stop film 102. The word-line cutting structure WLC, the cell contact 150, the dummy channel structure DCH, and the input/output contact 170 may extend through a portion of the etch stop film 102. For example, one end of each of the word-line cutting structure WLC, the cell contact 150, the dummy channel structure DCH, and the input/output contact 170 may be embedded in the etch stop film 102. The top face WLC_US of the word-line cutting structure WLC, the top face 150_US of the cell contact 150, the top face DCH_US of the dummy channel structure DCH, and the top face of the input/output contact 170 may be disposed in the etch stop film 102. In the third direction Z, the topmost face 130_US of the channel structure CH may be disposed above one, some, or all of the top face DCH_US of the dummy channel structure DCH, the top face 150_US of the cell contact 150, and the top face WLC_US of the word-line cutting structure WLC. The topmost face 130_US of the channel structure CH may be closer to the fourth face 105b of the source structure 105 than one, some, or all of the top face DCH_US of the dummy channel structure DCH, the top face 150_US of the cell contact 150, and the top face WLC_US of the word-line cutting structure WLC may be. The top face WLC_US of the word-line cutting structure WLC, the top face 150_US of the cell contact 150, and the top face DCH_US of the dummy channel structure DCH may be substantially coplanar with each other. However, the present disclosure is not limited thereto.

In some implementations, each of the trenches 105t may be formed in a corresponding manner to each of the word-line cutting structure WLC, the cell contact 150, and the input/output contact 170. Each of the word-line cutting structure WLC, the cell contact 150, and the input/output contact 170 may be disposed on each of the etch stop films 102 spaced apart from each other.

The input/output via 370 may extend through a portion of the etch stop film 102 so as to connect the first input/output pad 195 and the input/output contact 170 to each other. For example, the third spacer film 373 may extend along a portion of a side face of the third filling film 374 and may expose a portion of a side face of the third filling film 374. Accordingly, the portion of the third filling film 374 may contact the etch stop film 102. In some implementations, the third spacer film 373 may extend along an entirety of the side face of the third filling film 374.

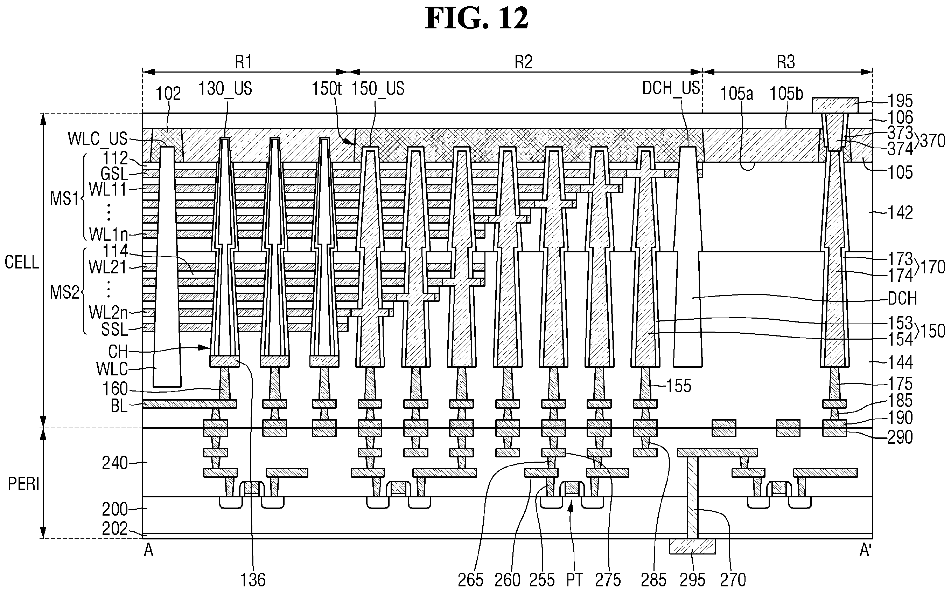

In the semiconductor memory device according to some implementations referring to FIG. 12, unlike the semiconductor memory device as described using FIG. 11, the plurality of cell contacts 150 and the dummy channel structure DCH may be disposed on one etch stop film 102. In some implementations, at least some of the cell contacts 150 may be disposed on one etch stop film 102. In some implementations, the cell contact 150 and the dummy channel structure DCH adjacent to each other may be disposed on one etch stop film 102. At least one plug 103 having various sizes or shapes on a plane defined by the first direction X and the second direction Y may be disposed.

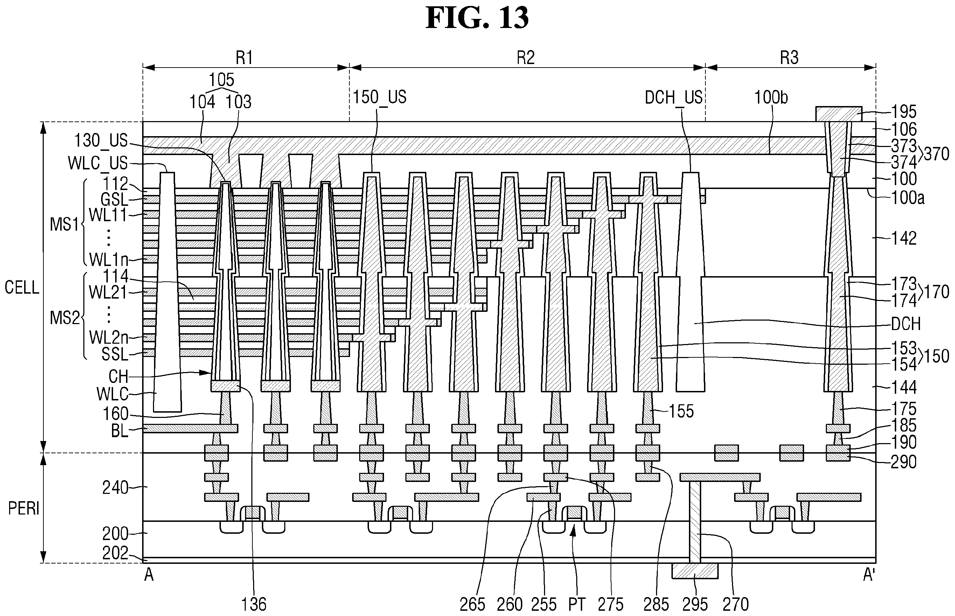

Referring to FIG. 13, the semiconductor memory device according to some implementations may include a cell substrate 100 instead of the semiconductor layer 101, unlike the semiconductor memory device as described using FIG. 4. The cell substrate 100 may include a fifth face 100a and a sixth face 100b opposite to each other. The first insulating layer 106 may be disposed on the sixth face 100b, and the mold structures MS1 and MS2 may be disposed on the fifth face 100a. The cell substrate 100 may be embodied as, for example, a silicon substrate.

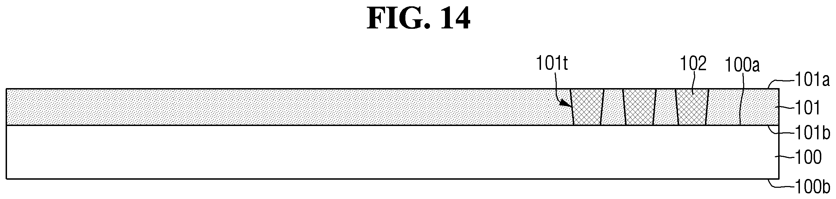

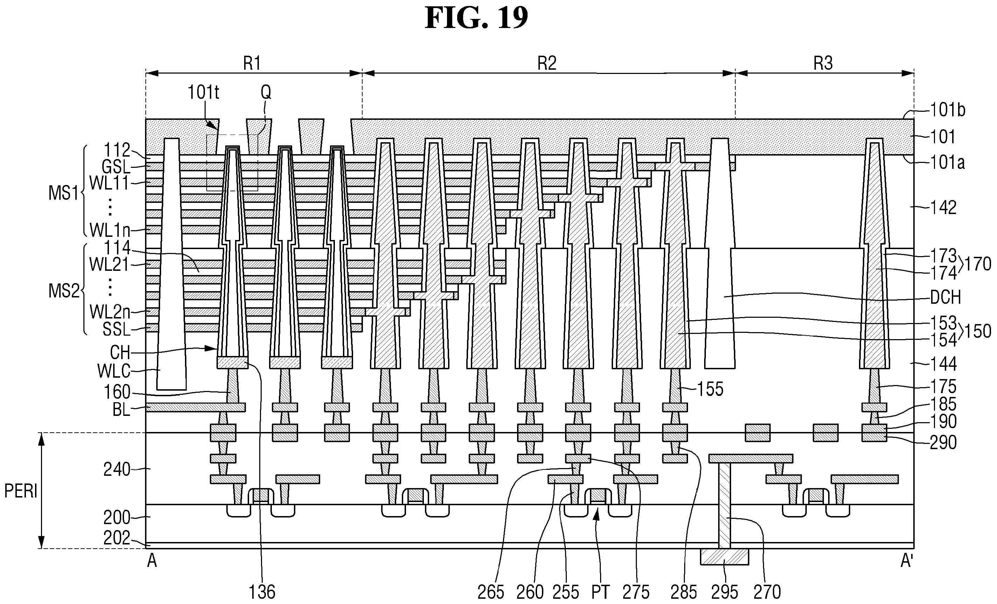

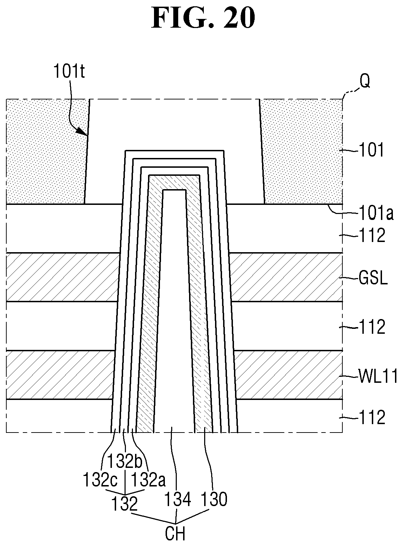

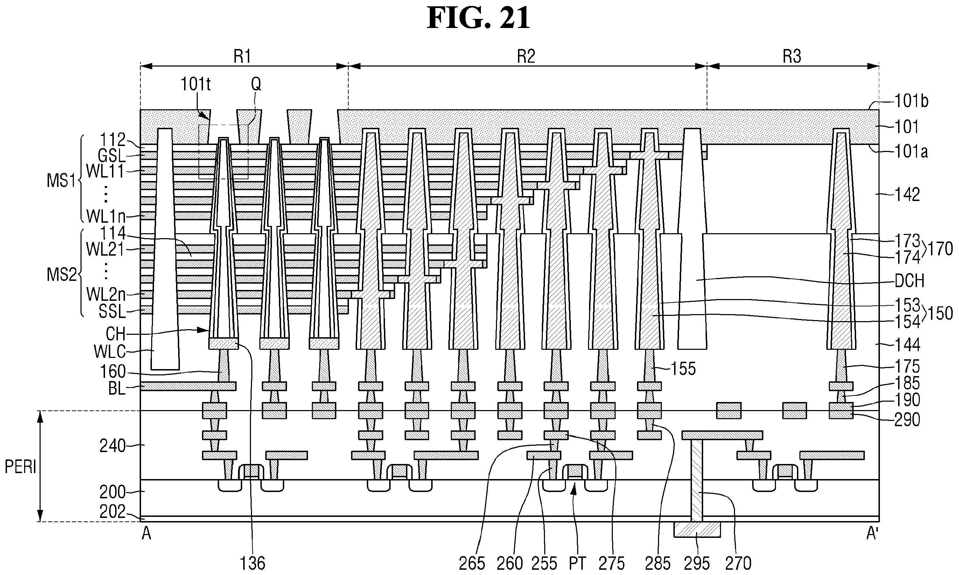

FIGS. 14 to 23 are cross-sectional views of intermediate structures corresponding to intermediate steps for illustrating a method for manufacturing a semiconductor memory device according to some implementations. For convenience of description, following descriptions are based on differences thereof from those as set forth with reference to FIGS. 1 to 13. For reference, FIG. 20 is an enlarged view of a Q area of FIG. 19, and FIG. 22 and FIG. 23 are enlarged views of the Q area of FIG. 21.

Referring to FIG. 14, the cell substrate 100 may be provided. The cell substrate 100 may be embodied as a silicon wafer or another type of wafer. The semiconductor layer 101 may be formed on the cell substrate 100. The second face 101b of the semiconductor layer 101 may contact the fifth face 100a of the cell substrate 100.

The etch stop film 102 may be formed in the semiconductor layer 101. For example, a trench 101t exposing at least a portion of the cell substrate 100 may be formed in the semiconductor layer 101, and the etch stop film 102 filling the trench 101t may be formed. The etch stop film 102 may be made of a material having an etch selectivity with respect to, for example, a material of each of the first mold insulating film 112 and the first mold sacrificial film 111 to be described below and thus may function as an etch stop film for forming a first pre-channel pCH1. For example, the etch stop film 102 may be etched more slowly than the material of each of the first mold insulating film 112 and the first mold sacrificial film 111, by one or more etchants. The etch stop film 102 may be formed at a position where the channel structure CH will be formed s. In some implementations, each of the etch stop films 102 may be formed at each of positions where each of the channel structures CH will be formed later.

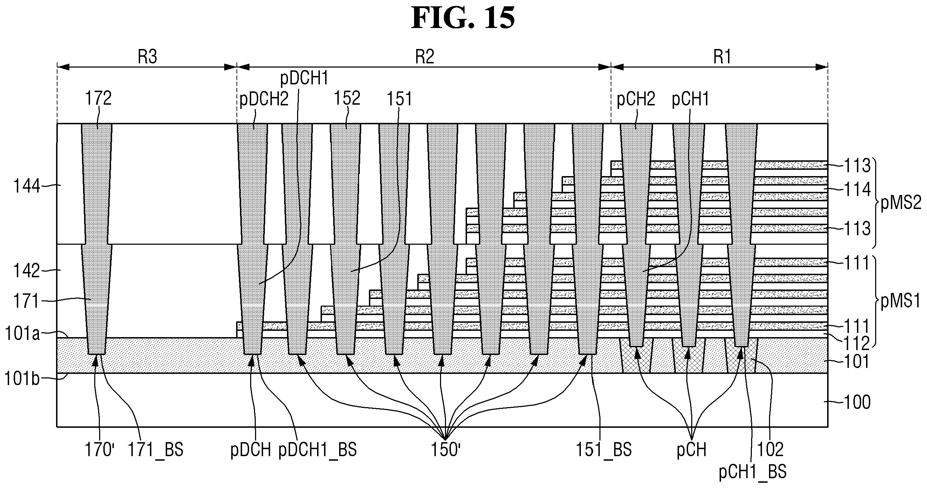

Referring to FIG. 15, a first pre-mold pMS1 may be formed on the semiconductor layer 101. The first pre-mold pMS1 may be formed on the first face 101a of the semiconductor layer 101. The first pre-mold pMS1 may include a plurality of first mold insulating films 112 and a plurality of first mold sacrificial films 111 alternately stacked on top of each other while being disposed on the semiconductor layer 101. The first mold sacrificial film 111 may include a material having an etching selectivity with respect to a material of the first mold insulating film 112. For example, the first mold insulating film 112 may include a silicon oxide film, and the first mold sacrificial film 111 may include a silicon nitride film.

The first pre-mold pMS1 in the second area R2 may be patterned in a stepped manner. Accordingly, the first pre-mold pMS1 in the second area R2 may be stacked in a stepwise manner.

The first interlayer insulating film 142 covering the first pre-mold pMS1 may be formed on the first face 101a of the semiconductor layer 101. The first pre-channel pCH1 extending through the first pre-mold pMS1 and the first interlayer insulating film 142 in the first area R1, a first pre-cell contact 151 and a first pre-dummy channel pDCH1 extending through the first pre-mold pMS1 and the first interlayer insulating film 142 in the second area R2, and a first pre-input/output contact 171 extending through the first pre-mold pMS1 and the first interlayer insulating film 142 in the third area R3 may be formed. The first pre-channel pCH1 may be formed on the etch stop film 102. The first pre-channel pCH1 may extend through a portion of the etch stop film 102, and a bottom face pCH1_BS of the first pre-channel pCH1 in a direction from the first face 101a of the semiconductor layer 101 toward the second face 101b thereof may be disposed in the etch stop film 102. The first pre-cell contact 151, the first pre-dummy channel pDCH1, and the first pre-input/output contact 171 may be formed on the semiconductor layer 101.

Each of the first pre-cell contact 151, the first pre-dummy channel pDCH1, and the first pre-input/output contact 171 may extend through a portion of the semiconductor layer 101. A bottom face 151_BS of the first pre-cell contact 151, a bottom face pDCH1_BS of the first pre-dummy channel pDCH1, and a bottom face 171_BS of the first pre-input/output contact 171 in the direction from the first face 101a of the semiconductor layer 101 to the second face 101b thereof may be disposed in the semiconductor layer 101, and may be closer to the second face 101b of the semiconductor layer 101 than the bottom face pCH1_BS of the pre-channel pCH1 may be.

Each of the first pre-channel pCH1, the first pre-cell contact 151, the first pre-dummy channel pDCH1, and the first pre-input/output contact 171 may include a material having an etching selectivity to a material of the first mold sacrificial film 111 and a material of the first mold insulating film 112. For example, each of the first pre-channel pCH1, the first pre-cell contact 151, the first pre-dummy channel pDCH1, and the first pre-input/output contact 171 may include polysilicon.

A second pre-mold pMS2 may be formed on the first pre-mold pMS1. The second pre-mold pMS2 may include a plurality of second mold insulating films 114 and a plurality of second mold sacrificial films 113 alternately stacked on top of each other while being disposed on the first pre-mold pMS1. Since forming the second pre-mold pMS2 may be similar to forming the first pre-mold pMS1, a detailed description of the former will be omitted below.

The second interlayer insulating film 144 covering the second pre-mold pMS2 may be formed on the first interlayer insulating film 142. A second pre-channel pCH2 extending through the second pre-mold pMS2 and the second interlayer insulating film 144 in the first area R1, a second pre-cell contact 152 and a second pre-dummy channel pDCH2 extending through the second pre-mold pMS2 and the second interlayer insulating film 144 in the second area R2, and a second pre-input/output contact 172 extending through the second pre-mold pMS2 and the second interlayer insulating film 144 in the third area R3 may be formed. Accordingly, a pre-channel pCH, a pre-cell contact 150', a pre-dummy channel pDCH, and a pre-input/output contact 170' may be formed. Forming the second pre-channel pCH2, the second pre-cell contact 152, the second pre-dummy channel pDCH2, and the second pre-input/output contact 172 may be respectively similar to forming the first pre-channel pCH1, the first pre-cell contact 151, the first pre-dummy channel pDCH1, and the first pre-input/output contact 171. Thus, a detailed description of the former will be omitted below.

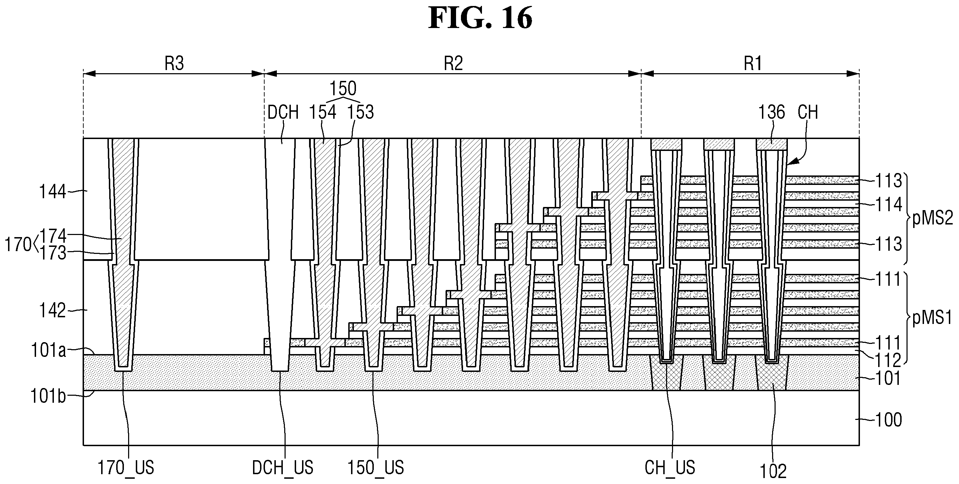

Referring to FIG. 16, the channel structure CH, the cell contact 150, the dummy channel structure DCH, and the input/output contact 170 may be formed.

For example, the pre-channel pCH, the pre-cell contact 150', the pre-dummy channel pDCH, and the pre-input/output contact 170' may be selectively removed. The channel structure CH, the cell contact 150, the dummy channel structure DCH and the input/output contact 170 may be formed so as to respectively fill spaces respectively obtained via the removal of the pre-channel pCH, the pre-cell contact 150', the pre-dummy channel pDCH and the preinput/output contact 170'. Accordingly, in the direction from the first face 101a to the second face 101b of the semiconductor layer 101, the top face 150_US of the cell contact 150, the top face DCH_US of the dummy channel structure DCH, and the top face 170_US of the input/output contact 170 may be closer to the second face 101b of the semiconductor layer 101 than the top face CH_US of the channel structure CH may be. For example, the top face 150_US of the cell contact 150, the top face DCH_US of the dummy channel structure DCH, and the top face 170_US of the input/output contact 170 may be substantially coplanar with each other. However, the present disclosure is not limited thereto.

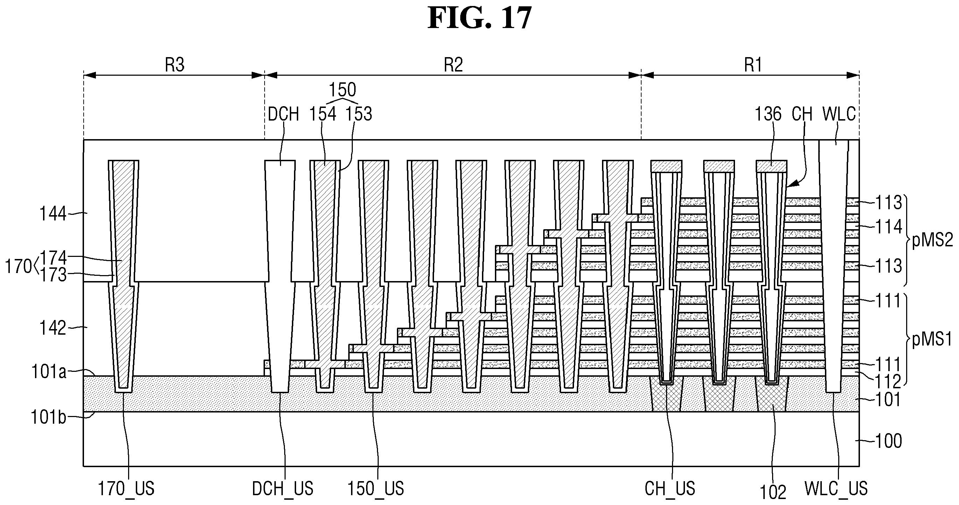

Referring to FIG. 17, the word-line cutting structure WLC may be formed. The word-line cutting structure WLC may extend in the first direction (X in FIG. 3) so as to cut the first pre-mold pMS1 and the second pre-mold pMS2. In the direction from the first face 101a of the semiconductor layer 101 toward the second face 101b thereof, the top face WLC_US of the word-line cutting structure WLC may be closer to the second face 101b of the semiconductor layer 101 than the top face CH_US of the channel structure CH may be. The top face WLC_US of the word-line cutting structure WLC may be substantially coplanar with at least one of the top face 150_US of the cell contact 150, the top face DCH_US of the dummy channel structure DCH, and the top face 170_US of the input/output contact 170. However, the present disclosure is not limited thereto.

The plurality of gate electrodes GSL, WL11 to WL1n, WL21 to WL2n, and SSL may be formed. For example, the first and second mold sacrificial films 111 and 113 exposed through the word-line cutting structure WLC may be selectively removed. Subsequently, the gate electrodes GSL, WL11 to WL1n, WL21 to WL2n, and SSL may be formed so as to respectively fill spaces respectively obtained via the removal of the first and second mold sacrificial films 111 and 113. Thus, the first mold structure MS1 including the plurality of first gate electrodes GSL, and WL11 to WL1n and the second mold structure MS2 including the plurality of second gate electrodes WL21 to WL2n, and SSL may be formed. After the first mold structure MS1 and the second mold structure MS2 have been formed, the word-line cutting structure WLC may be filled with an insulating material.

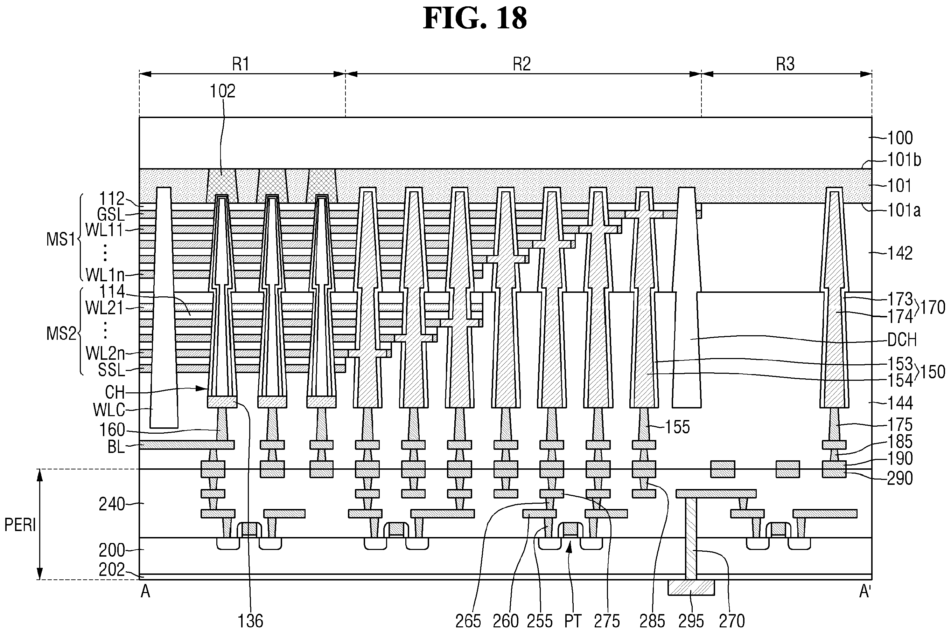

Referring to FIG. 18, the bit-line contact 160 may be formed on the channel pad 136. The first contact 155 may be formed on the cell contact 150. The second contact 175 may be formed on the input/output contact 170. The bit-line BL may be formed. The bit-line BL may be electrically connected to the channel pad 136 via the bit-line contact 160, may be electrically connected to the cell contact 150 via the first contact 155, and may be electrically connected to the input/output contact 170 via the second contact 175.

The first bonding contact 185 and the first bonding metal 190 may be formed. The first bonding metal 190 may be electrically connected to the bit-line BL via the first bonding contact 185.

Subsequently, the cell structure CELL may be stacked on the peripheral circuit structure PERI. The cell structure CELL may be stacked on the peripheral circuit structure PERI such that the first face 101a of the semiconductor layer 101 and the front face of the peripheral circuit substrate 200 face each other. The first bonding metal 190 and the second bonding metal 290 may be bonded to each other. Thus, the cell structure CELL may be stacked on the peripheral circuit structure PERI.

Referring to FIG. 19 and FIG. 20, the cell substrate 100 may be removed. Subsequently, the etch stop film 102 may be removed to form the trench 101t. Accordingly, the top face CH_US of the channel structure CH may be exposed. Specifically, a portion of the information storage film 132 of the channel structure CH may be exposed. That is, only one end of the channel structure CH is exposed, while the word-line cutting structure WLC, the cell contact 150, the dummy channel structure DCH, and the input/output contact 170 are not exposed.

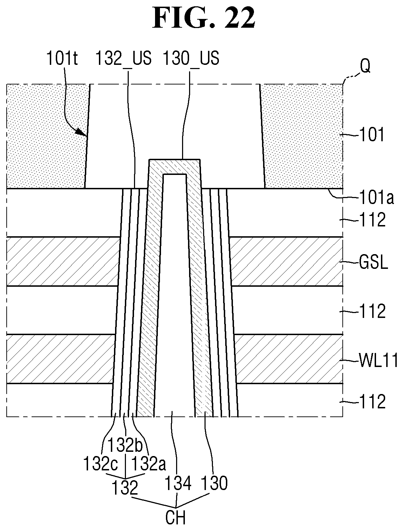

Referring to FIG. 21 and FIG. 22, the exposed portion of the information storage film 132 may be removed. Accordingly, the channel film 130 may be exposed. The top face 130_US of the channel film 130 and at least a portion of the side face of the channel film 130 may be exposed. Further, the top face 132_US of the information storage film 132 may be exposed. In some implementations, the top face 132_US of the information storage film 132 may be substantially coplanar with the first face 101a of the semiconductor layer 101.

Then, referring to FIGS. 4 and 5, the source structure 105 may be formed on the second face 102b of the semiconductor layer 101. The plug 103 may fill the trench 101t, and the plate 104 may cover the second face 102b of the semiconductor layer 101.

Subsequently, the first insulating layer 106 may be formed on the source structure 105. The input/output via 370 extending through the first insulating layer 106, the source structure 105, and the semiconductor layer 101 may be formed. The first input/output pad 195 may be formed on the input/output via 370.

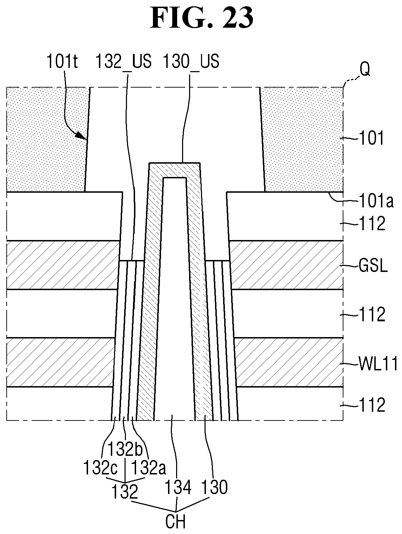

In some implementations, referring to FIGS. 21 and 23, a portion of the information storage film 132 exposed through the trench 101t may be removed. Accordingly, the top face 132_US of the information storage film 132 may be disposed below the first face 101a of the semiconductor layer 101. Further, at least a portion of the gate electrode ECL may be exposed.

Then, referring to FIGS. 6 and 7, the source structure 105 may be formed on the second face 102b of the semiconductor layer 101. The plug 103 may fill the trench 101t, and the plate 104 may cover the second face 102b of the semiconductor layer 101. Subsequently, the first insulating layer 106, the input/output via 370, and the first input/output pad 195 may be formed.

In one example, in a process of removing the portion of the information storage film 132 so as to expose one end of the channel film 130, not only one end of the channel structure CH, but also one end of the word-line cutting structure WLC, one end of the cell contact 150, one end of the dummy channel structure DCH, and one end of the input/output contact 170 may be exposed. In this case, each of one end of the word-line cutting structure WLC, one end of the cell contact 150, one end of the dummy channel structure DCH, and one end of the input/output contact 170 may be at least partially removed in the process of removing the portion of the information storage film 132. For example, in the above process, a portion of the first spacer film 153 of the cell contact 150 and/or a portion of the second spacer film 173 of the input/output contact 170 may be removed, and the source structure 105 may be formed on the first spacer film 153 and the second spacer film 173. In this regard, due to the etching of the first spacer film 153 and the second spacer film 173, a distance between the source structure 105 and the first filling film 154 of the cell contact 150 and a distance between the source structure 105 and the second filling film 174 of the input/output contact 170 may decrease. Further, in the above process, a void may be formed at one end of the dummy channel structure DCH and/or one end of the word-line cutting structure WLC, and the source structure 105 may be formed in the void. Accordingly, a distance between the source structure 105 and each of the gate electrodes GSL, WL11 to WL1n, WL21 to WL2n, and SSL may be reduced. Accordingly, a defect may occur in the semiconductor memory device.

However, in some methods for manufacturing the semiconductor memory device according to some implementations of the present disclosure, the process of removing the portion of the information storage film 132 so as to expose one end of the channel film 130 may be performed while only one end of the channel structure CH is exposed. That is, in this process, the cell contact 150, the input/output contact 170, the word-line cutting structure WLC, and the dummy channel structure DCH are not exposed. Therefore, the method for manufacturing the semiconductor memory device according to some implementations of the present disclosure may prevent the cell contact 150, the input/output contact 170, the word-line cutting structure WLC, and the dummy channel structure DCH from being etched, or reduce an amount of the etching, thereby reducing occurrence of the defect in the semiconductor memory device.

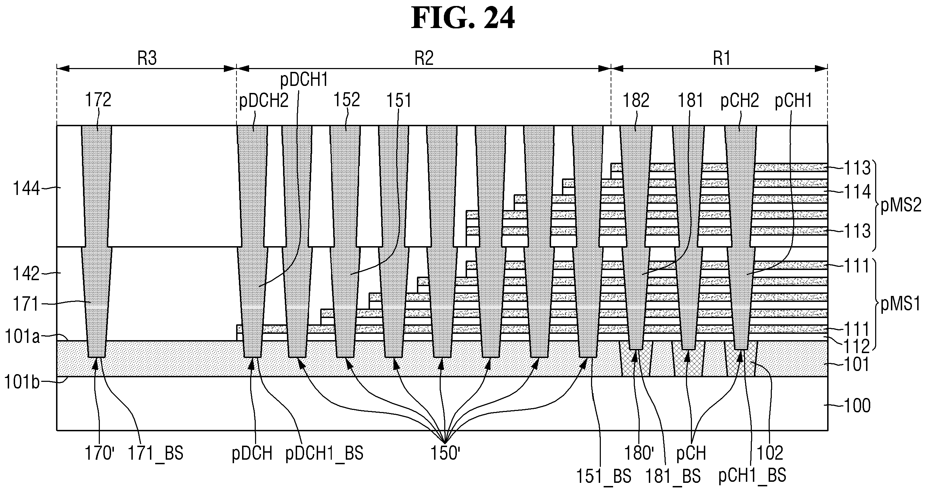

FIGS. 24 to 27 are cross-sectional views of intermediate structures corresponding to intermediate steps for illustrating a method for manufacturing a semiconductor memory device according to some implementations. For convenience of description, the following descriptions are based on differences thereof from those as set forth with reference to FIGS. 1 to 23. For reference, FIG. 24 is a diagram to illustrate a step after FIG. 14.

Referring to FIG. 24, the etch stop film 102 may be further formed at a position where the source contact 180 will be formed later. A first pre-source contact 181 may extend through the first pre-mold pMS1 and the first interlayer insulating film 142. The first pre-source contact 181 may be formed on the etch stop film 102. The first pre-source contact 181 may extend through a portion of the etch stop film 102. A bottom face 181_BS of the first pre-source contact 181 in the direction from the first face 101a of the semiconductor layer 101 toward the second face 101b may be disposed within the stop film 102. The bottom face 181_BS of the first pre-source contact 181 may be substantially coplanar with the bottom face pCH1_BS of the first pre-channel pCH1.

A second pre-source contact 182 may extend through the second pre-mold pMS2 and the second interlayer insulating film 144. Accordingly, the pre-source contact 181 may be formed.

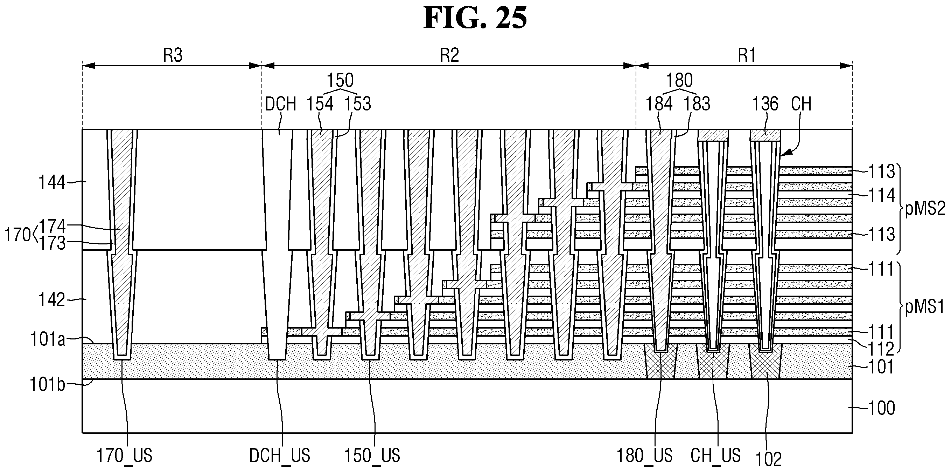

Referring to FIG. 25, the source contact 180 may be further formed. For example, a pre-source contact 180' may be selectively further removed. The source contact 180 may be formed so as to fill a space obtained via the selective removal of the pre-source contact 180'. The fourth filling film 184 may fill a trench defined by the fourth spacer film 183. Accordingly, in the direction from the first face 101a of the semiconductor layer 101 to the second face 101b, the top face 180_US of the source contact 180 may be closer to the second face 101b of the semiconductor layer 101 than the top face CH_US of the channel structure CH may be. For example, the top face 180_US of the source contact 180 may be substantially coplanar with at least one of the top face 150_US of the cell contact 150, the top face DCH_US of the dummy channel structure DCH, and the top face 170_US of the input/output contact 170. However, the present disclosure is not limited thereto.

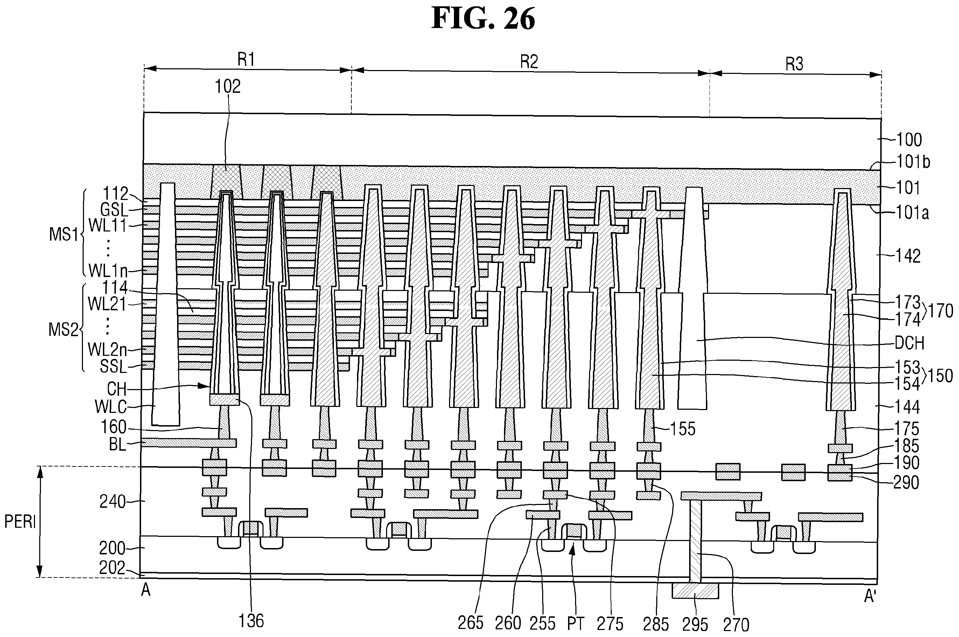

Referring to FIG. 26, the plurality of gate electrodes GSL, WL11 to WL1n, WL21 to WL2n, and SSL, and the word-line cutting structure WLC may be formed. The cell structure CELL may be stacked on the word-line peripheral circuit structure PERI.

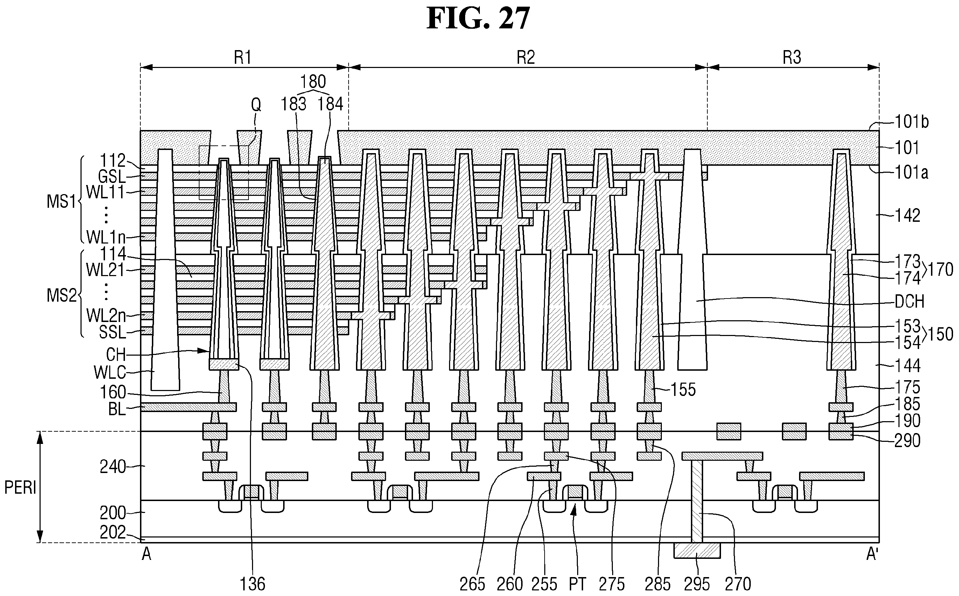

Referring to FIG. 27, the cell substrate 100 may be removed. Subsequently, the etch stop film 102 may be removed to form the trench 101t. Accordingly, a portion of the source contact 180 may be further exposed. Specifically, a portion of the fourth spacer film 183 may be further exposed.

Subsequently, the exposed portion of the fourth spacer film 183 may be further removed. Accordingly, a portion of the fourth filling film 184 may be exposed. A side face and a top face of the fourth filling film 184 may be exposed. The top face of the fourth spacer film 183 may be substantially coplanar with the first face 101a of the semiconductor layer 101.

Subsequently, referring to FIG. 10, the source structure 105, the first insulating layer 106, the input/output via 370, and the first input/output pad 195 may be formed. The plug 103 may contact the fourth filling film 184.

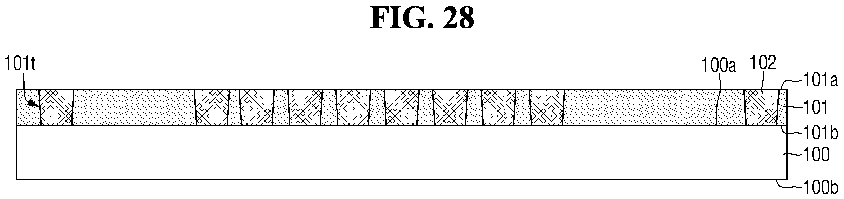

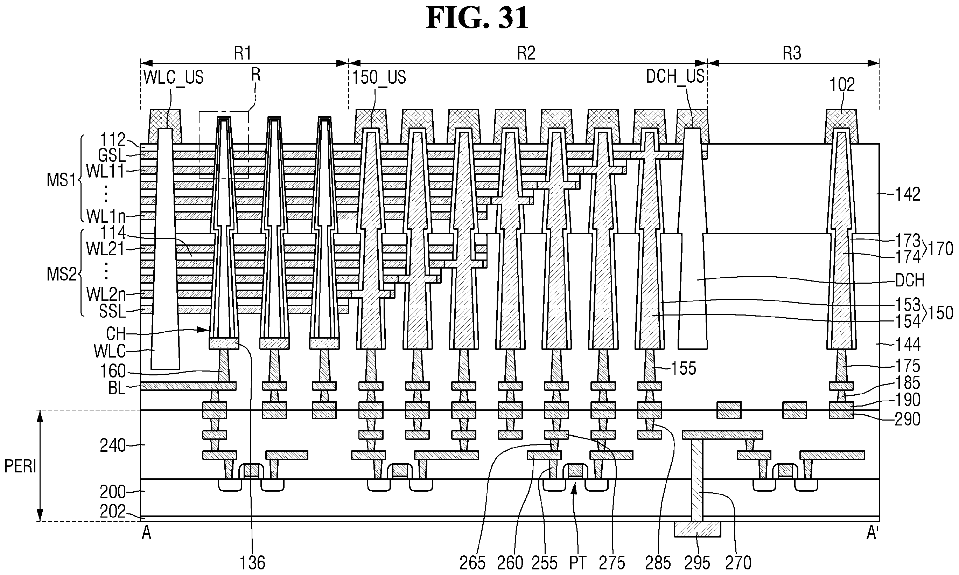

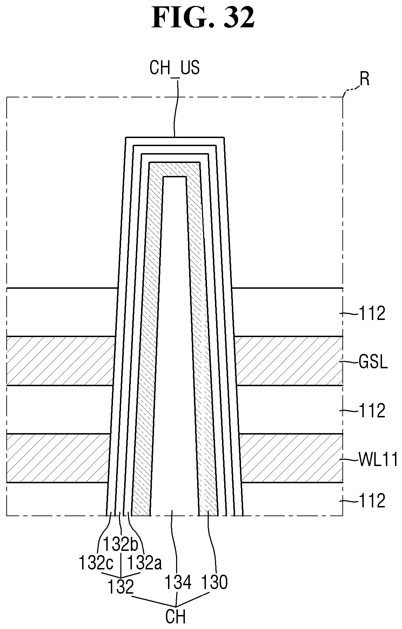

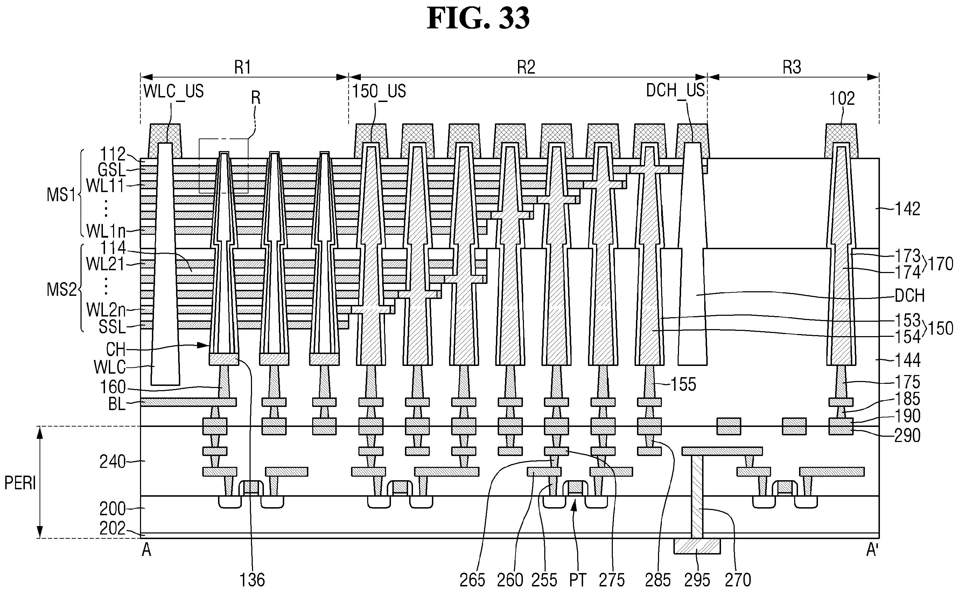

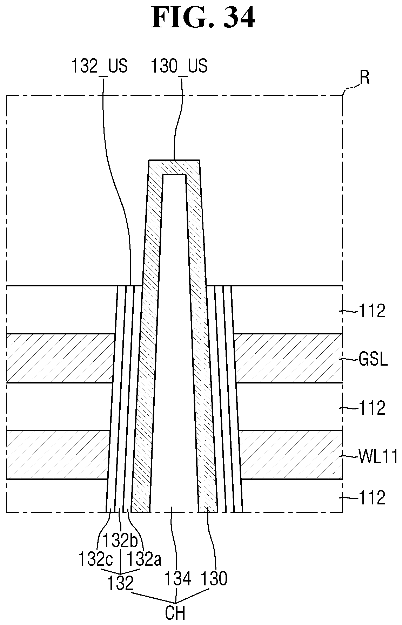

FIGS. 28 to 34 are cross-sectional views of intermediate structures corresponding to intermediate steps for illustrating a method for manufacturing a semiconductor memory device according to some implementations. For convenience of description, following descriptions are based on differences thereof from those as set forth with reference to FIGS. 1 to 23. For reference, FIG. 32 is an enlarged view of a R area of FIG. 31, and FIG. 34 is an enlarged view of the R area of FIG. 33.

Referring to FIG. 28, the etch stop film 102 may be formed in the semiconductor layer 101. The etch stop film 102 may be made of a material having an etch selectivity with respect to, for example, a material of each of the first mold insulating film 112 and the first mold sacrificial film 111 to be described below and thus may function as an etch stop film for forming the first pre-channel pCH1. The etch stop film 102 may be formed at a position other than a position where the channel structure CH will be formed later. The etch stop film 102 may be formed, for example, at a position where each of the cell contact 150, the dummy channel structure DCH, the word-line cutting structure WLC, and the input/output contact 170 will be formed later. In some implementations, the etch stop film 102 may be formed at a position where each of the cell contact 150, the dummy channel structure DCH, the word-line cutting structure WLC, and the input/output contact 170 will be formed later.

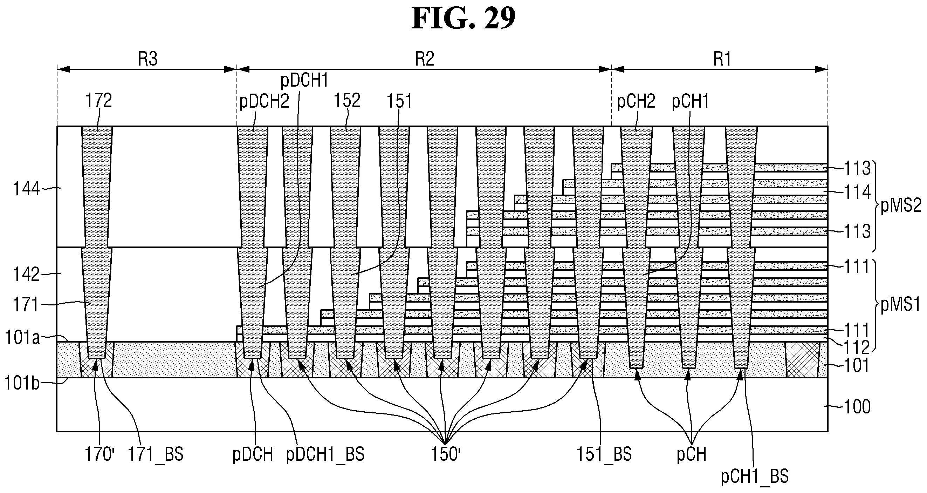

Referring to FIG. 29, a pre-channel pCH may be formed on the semiconductor layer 101. Each of a pre-cell contact 150', a pre-dummy channel pDCH, and a pre-input/output contact 170 ' may be formed on each of the etch stop films 102.

A first pre-channel pCH1 may extend through a portion of the semiconductor layer 101. A bottom face pCH1_BS of the first pre-channel pCH1 in the direction from the first face 101a to the second face 101b of the semiconductor layer 101 may be disposed in the semiconductor layer 101. Each of the pre-cell contact 150', the pre-dummy channel pDCH, and the pre-input/output contact 170' may extend through a portion of each of the etch stop films 102. A bottom face 151_BS of the first pre-cell contact 151, a bottom face pDCH1_BS of the first pre-dummy channel pDCH1, and a bottom face 171_BS of the first pre-input/output contact 171 may be disposed in the etch stop film 102. In the direction from the first face 101a of the semiconductor layer 101 to the second face 101b thereof, the bottom face pCH1_BS of the first pre-channel pCH1 may be closer to the second face 101b of the semiconductor layer 101 than each of the bottom face 151_BS of the first pre-cell contact 151, the bottom face pDCH1_BS of the first pre-dummy channel pDCH1, and the bottom face 171_BS of the first pre-input/output contact 171 may be.

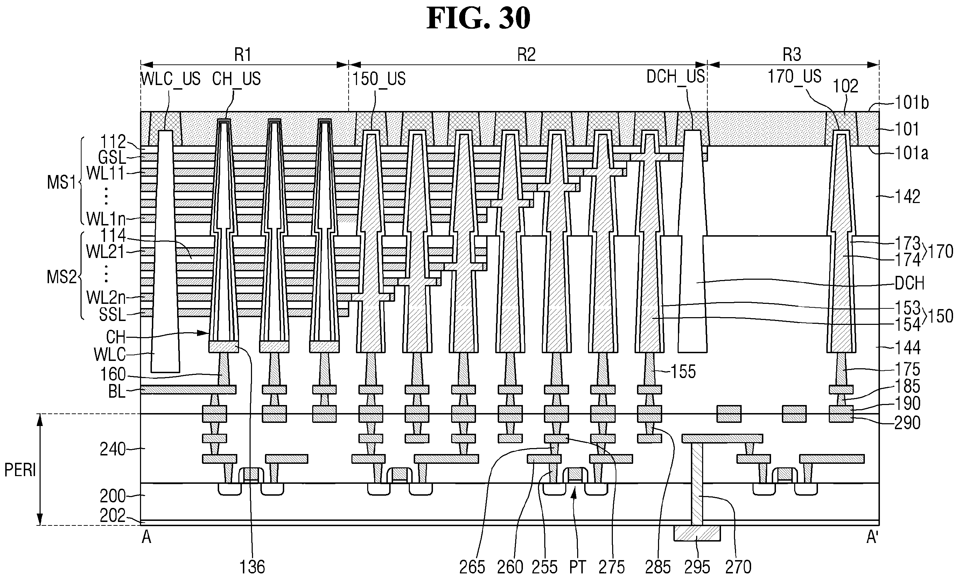

Referring to FIG. 30, the channel structure CH, the cell contact 150, the dummy channel structure DCH, and the input/output contact 170 may be formed. The plurality of gate electrodes GSL, WL11 to WL1n, WL21 to WL2n, and SSL, and the word-line cutting structure WLC may be formed. Accordingly, in the direction from the first face 101a to the second face 101b of the semiconductor layer 101, the top face CH_US of the channel structure CH may be closer to the second face 101b of the semiconductor layer 101 than each of the top face 150_US of the cell contact 150, the top face DCH_US of the dummy channel structure DCH, the top face 170_US of the input/output contact 170, and the top face WLC_US of the word-line cutting structure WLC may be. For example, the top face 150_US of the cell contact 150, the top face DCH_US of the dummy channel structure DCH, the top face 170_US of the input/output contact 170, and the top face WLC_US of the word-line cutting structure WLC may be substantially coplanar with each other. However, the present disclosure is not limited thereto.

The cell structure CELL may be stacked on the peripheral circuit structure PERI.

Referring to FIG. 31 and FIG. 32, the cell substrate 100 may be removed, and then, the semiconductor layer 101 may be removed. Accordingly, a portion of the channel structure CH may be exposed. Specifically, a portion of the information storage film 132 may be exposed. Further, a top face of the first mold structure MS1 in the third direction Z may be exposed.

Referring to FIG. 33 and FIG. 34, the exposed portion of the information storage film 132 may be removed. Accordingly, the channel film 130 may be exposed. A top face 130_US of the channel film 130 and at least a portion of a side face of the channel film 130 may be exposed. Further, a top face 132_US of the information storage film 132 may be exposed. In some implementations, the top face 132_US of the information storage film 132 may be substantially coplanar with the first face 101a of the semiconductor layer 101.

Then, referring to FIG. 11, the source structure 105 may be formed on the top face of the first mold structure MS1. The source structure 105 may fill a space between the etch stop films 120 while being disposed on the top face of the first mold structure MS1. Subsequently, the first insulating layer 106, the input/output via 370, and the first input/output pad 195 may be formed.

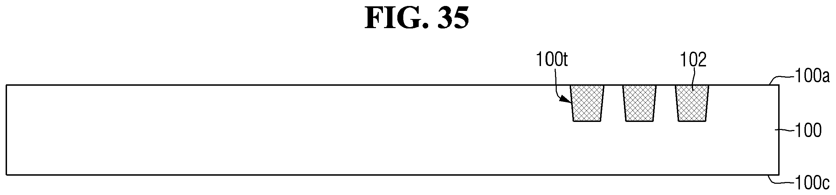

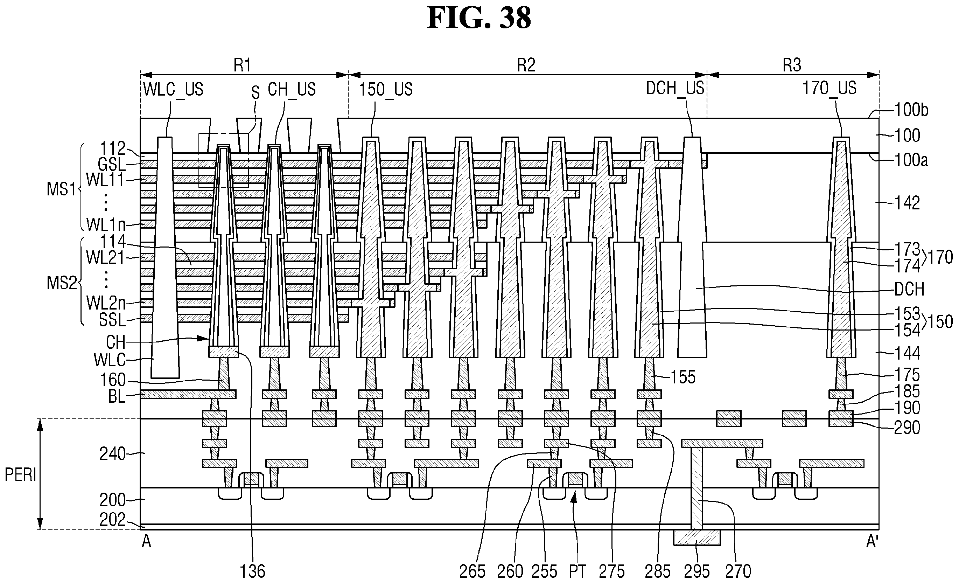

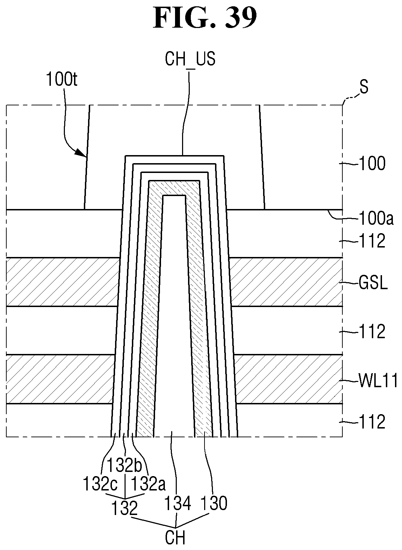

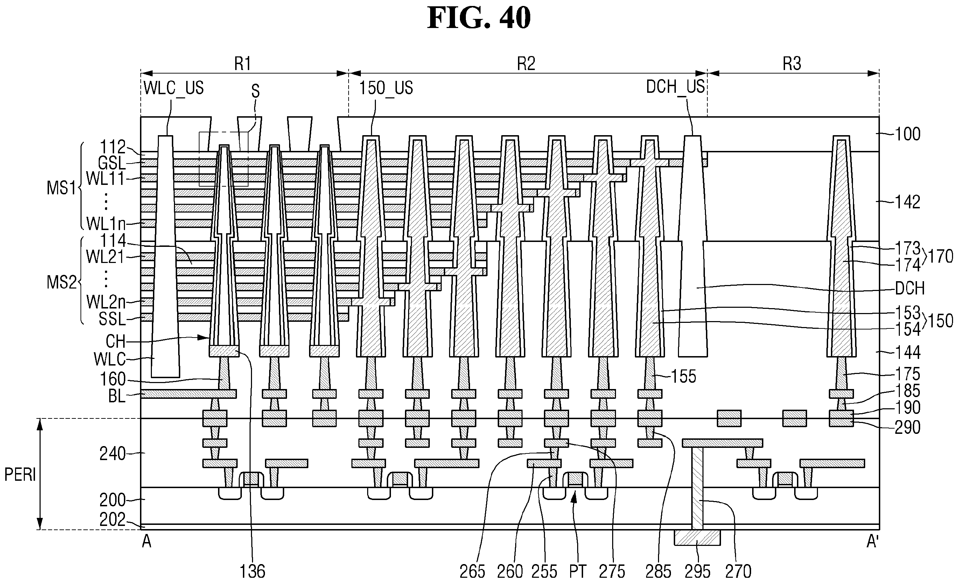

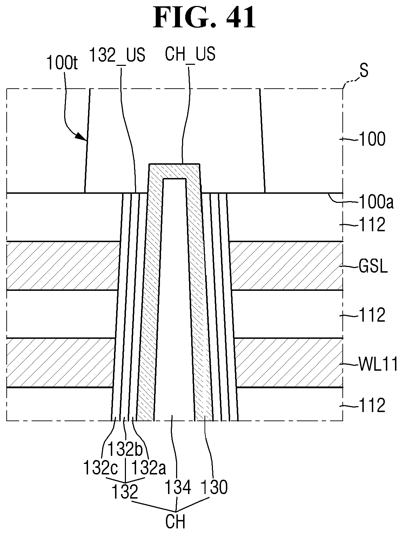

FIG. 35 to FIG. 41 are cross-sectional views of intermediate structures corresponding to intermediate steps for illustrating a method for manufacturing a semiconductor memory device according to some implementations. For convenience of description, following descriptions are based on differences thereof from those as set forth with reference to FIGS. 1 to 23. For reference, FIG. 39 is an enlarged view of a S area of FIG. 38, and FIG. 41 is an enlarged view of the S area of FIG. 40.

Referring to FIG. 35, the cell substrate 100 including a fifth face 100a and a seventh face 100c opposite to each other may be provided.

The etch stop film 102 may be formed in the cell substrate 100. For example, after the trench 100t extending from the fifth face 100a of the cell substrate 100 has been formed, the etch stop film 102 may be formed so as to fill the trench 100t. A bottom face of the trench 100t in the direction from the seventh face 100b of the cell substrate 100 toward the fifth face 100a thereof may be disposed in the cell substrate 100.

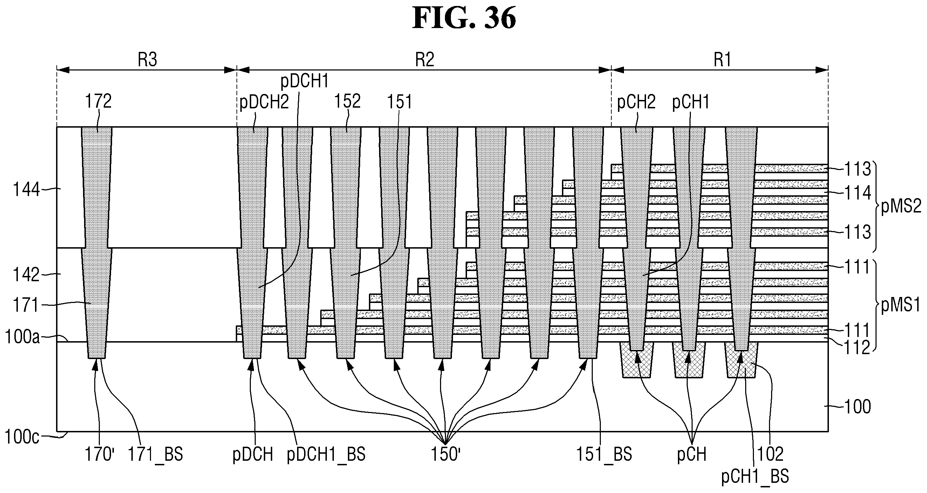

Referring to FIG. 36, the first and second pre-molds pMS1 and pMS2 may be formed on the fifth face 100a of the cell substrate 100. The pre-channel pCH may be formed on the etch stop film 102. Each of the pre-cell contact 150', the pre-dummy channel pDCH, and the pre-input/output contact 170' may be formed on the cell substrate 100.

The first pre-channel pCH1 may extend through a portion of the cell substrate 100. The bottom face pCH1_BS of the first pre-channel pCH1 in the direction from the fifth face 100a of the cell substrate 100 toward the seventh face 100c thereof may be disposed in the cell substrate 100. Each of the pre-cell contact 150', the pre-dummy channel pDCH and the preinput/output contact 170' may extend through a portion of the etch stop film 102. Each of the bottom face 151_BS of the first pre-cell contact 151, the bottom face pDCH1_BS of the first pre-dummy channel pDCH1, and the bottom face 171_BS of the first pre-input/output contact 171 may be disposed in the etch stop film 102. In the direction from the fifth face 100a of the cell substrate 100 toward the seventh face 100c thereof, each of the bottom face 151_BS of the first pre-cell contact 151, the bottom face pDCH1_BS of the first pre-dummy channel pDCH1, and the bottom face 171_BS of the first pre-input/output contact 171 may be closer to the seventh face 100c of the cell substrate 100 than the bottom face pCH1_BS of the first pre-channel pCH1 may be.

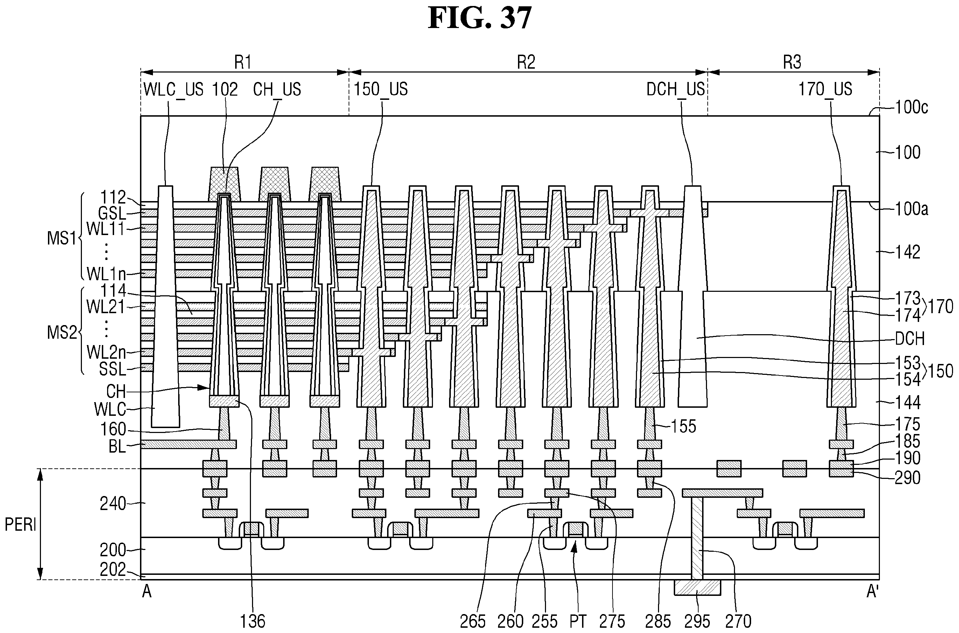

Referring to FIG. 37, the channel structure CH, the cell contact 150, the dummy channel structure DCH, and the input/output contact 170 may be formed. The plurality of gate electrodes GSL, WL11 to WL1n, WL21 to WL2n, and SSL, and the word-line cutting structure WLC may be formed. Accordingly, in the direction from the fifth face 100a of the cell substrate 100 toward the seventh face 100c thereof, a spacing between each of the top face 150_US of the cell contact 150, the top face DCH_US of the dummy channel structure DCH, the top face 170_US of the input/output contact 170, and the top face WLC_US of the word-line structure WLC and the fifth face 100a of the cell substrate 100 may be larger than a spacing between the top face CH_US of the channel structure CH and the fifth face 100a of the cell substrate 100. For example, the top face 150_US of the cell contact 150, the top face DCH_US of the dummy channel structure DCH, the top face 170_US of the input/output contact 170, and the top face WLC_US of the word-line structure WLC may be substantially coplanar with each other. However, the present disclosure is not limited thereto.

The cell structure CELL may be stacked on the peripheral circuit structure PERI.

Referring to FIG. 38 and FIG. 39, then, a portion of the cell substrate 100 may be etched. The cell substrate 100 may be etched from the seventh face 100c of the cell substrate 100. Accordingly, the cell substrate 100 may include the fifth face 100a and the sixth face 100b opposite to each other. The etch stop film 102 may function as an etch stop film in the process of etching the cell substrate 100. The sixth face 100b of the cell substrate 100 may expose the top face of the etch stop film 102. For example, the sixth face 100b of the cell substrate 100 and a top face of the etch stop film 102 may be substantially coplanar with each other.

Subsequently, the etch stop film 102 may be removed to form the trench 100t. Accordingly, the top face CH_US of the channel structure CH may be exposed. Specifically, for example, a portion of the information storage film 132 of the channel structure CH may be exposed.

Referring to FIG. 40 and FIG. 41, the exposed portion of the information storage film 132 may be removed. Accordingly, the channel film 130 may be exposed. The top face 130_US of the channel film 130 and at least a portion of a side face of the channel film 130 may be exposed. Further, the top face 132_US of the information storage film 132 may be exposed. In some implementations, the top face 132_US of the information storage film 132 may be substantially coplanar with the fifth face 100a of the cell substrate 100.

Then, referring to FIG. 13, the source structure 105 may be formed on the sixth face 100b of the cell substrate 100. The plug 103 may fill the trench 100t, and the plate 104 may cover the sixth face 100b of the cell substrate 100.

Subsequently, the first insulating layer 106 may be formed on the source structure 105. The input/output via 370 extending through the first insulating layer 106, the source structure 105, and the semiconductor layer 101 may be formed. The first input/output pad 195 may be formed on the input/output via 370.

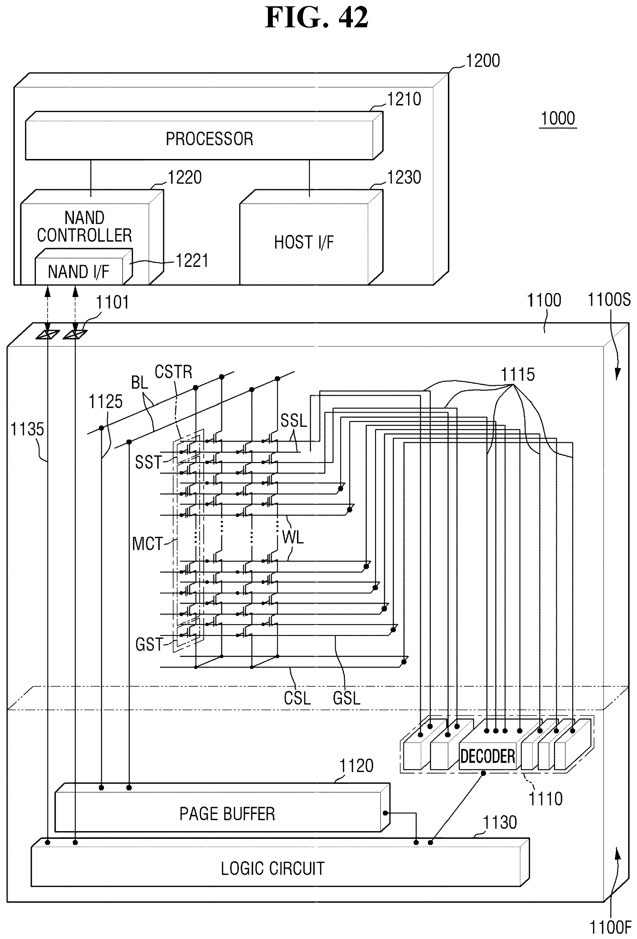

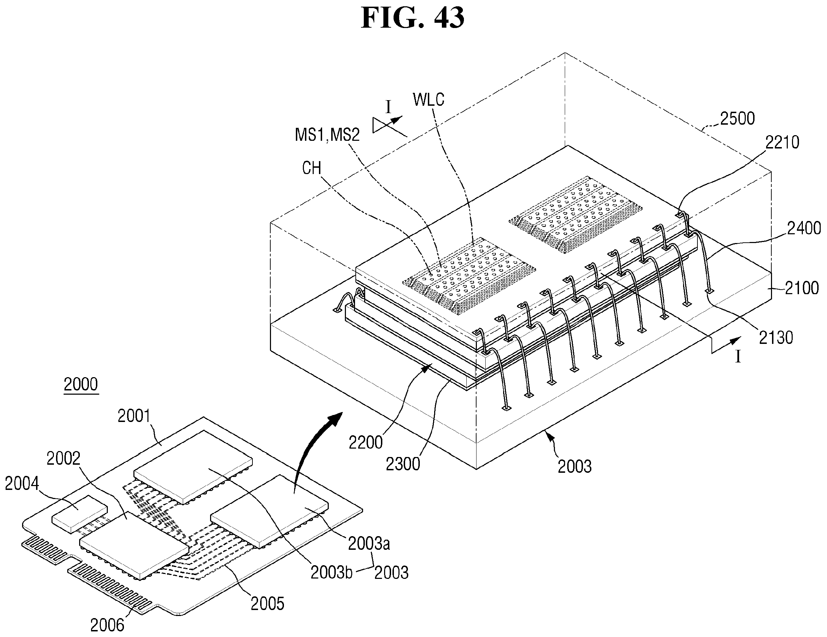

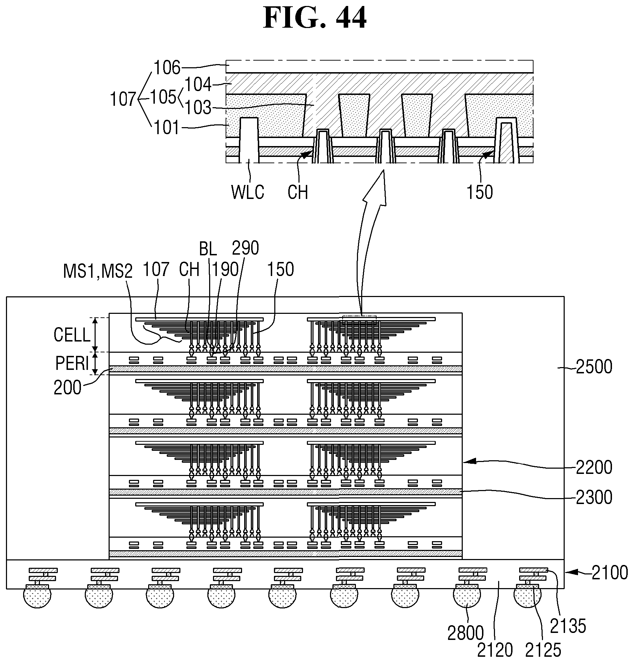

FIG. 42 is an illustrative block diagram for illustrating an electronic system according to some implementations. FIG. 43 is an illustrative perspective view for illustrating an electronic system according to some implementations. FIG. 44 is a schematic cross-sectional view taken along I-I of FIG. 43. For convenience of description, following descriptions are based on differences thereof from those as set forth with reference to FIGS. 1 to 13.

Referring to FIG. 42, an electronic system 1000 according to some implementations may include a semiconductor memory device 1100 and a controller 1200 electrically connected to the semiconductor memory device 1100. The electronic system 1000 may be a storage device storage device including one or a plurality of semiconductor devices 1100 or an electronic device electronic device including the storage device. For example, the electronic system 1000 may be embodied as a solid state drive device (SSD), a Universal Serial Bus (USB), a computing system, a medical device, or a communication device including one or a plurality of semiconductor memory devices 1100.

The semiconductor memory device 1100 may be embodied as a non-volatile memory device (for example, a NAND flash memory device). The semiconductor memory device 1100 may be embodied, as for example, the semiconductor device as described above with reference to FIGS. 1 to 13. The semiconductor memory device 1100 may include a first structure 1100F and a second structure 1100S on the first structure 1100F.

The first structure 1100F may be a peripheral circuit structure including a decoder circuit 1110 (e.g., the row decoder 33 of FIG. 1), a page buffer 1120 (e.g., the page buffer 35 of FIG. 1), and a logic circuit 1130 (e.g., the control logic 37 of FIG. 1). The first structure 1100F may be embodied as, for example, the peripheral circuit structure PERI as described above with reference to FIGS. 1 to 13.

The second structure 1100S may include the common source line CSL, the plurality of bit-lines BL and the plurality of cell strings CSTR as above-described with reference to FIG. 2. The cell strings CSTR may be connected to the decoder circuit 1110 via the word-line WL, at least one string select line SSL, and at least one ground select line GSL. Further, the cell strings CSTR may be connected to the page buffer 1120 via the bit-lines BL. The second structure 1100S may be embodied as, for example, the cell structure CELL as described above using FIGS. 1 to 13.

In some implementations, the common source line CSL and the cell string CSTR may be electrically connected to the decoder circuit 1110 via a first connection wiring 1115 extending from the first structure 1100F to the second structure 1100S. The first connection wiring 1115 may be embodied as, for example, the cell contact 150 as described above using FIGS. 1 to 13. That is, the cell contact 150 may electrically connect the gate electrodes GSL, WL, and SSL to the decoder circuit 1110 (for example, the row decoder 33 of FIG. 1).

In some implementations, the bit-lines BL may be electrically connected to the page buffer 1120 via a second connection wiring 1125. The second connection wiring 1125 may be embodied as, for example, the bit-line contact 160 as described above with reference to FIGS. 1 to 13. That is, the bit-line contact 160 may electrically connect the bit-lines BL to the page buffer 1120 (for example, the page buffer 35 in FIG. 1).

The semiconductor memory device 1100 may communicate with the controller 1200 via an input/output pad 1101 electrically connected to the logic circuit 1130 (e.g., the control logic 37 in FIG. 1). The input/output pad 1101 may be electrically connected to the logic circuit 1130 via an input/output connection line 1135 extending from the first structure 1100F to the second structure 1100S. The connection line 1135 may be embodied as, for example, the input/output contact structure 170 as described with reference to FIGS. 1 to 13.

The controller 1200 may include a processor 1210, a NAND controller 1220, and a host interface 1230. In some implementations, the electronic system 1000 may include a plurality of semiconductor memory devices 1100. In this case, the controller 1200 may control the plurality of semiconductor memory devices 1100.

The processor 1210 may control overall operations of the electronic system 1000 including the controller 1200. The processor 1210 may operate based on predefined firmware, and may control the NAND controller 1220 to access the semiconductor memory device 1100. The NAND controller 1220 may include a NAND interface 1221 that processes communication with the semiconductor memory device 1100. Via the NAND interface 1221, a control command for controlling the semiconductor memory device 1100, data to be written to memory cell transistors MCT of the semiconductor memory device 1100, and data to be read from the memory cell transistors MCT of the semiconductor memory device 1100 may be transmitted. The host interface 1230 may provide a communication function between the electronic system 1000 and an external host. Upon receiving a control command from an external host via the host interface 1230, the processor 1210 may control the semiconductor memory device 1100 in response to the control command.

Referring to FIG. 43 and FIG. 44, an electronic system according to some implementations may include a main substrate 2001, a main controller 2002 mounted on the main substrate 2001, at least one semiconductor package 2003, and at least one DRAM 2004. The semiconductor package 2003 and he DRAM 2004 may be connected to the main controller 2002 via line patterns 2005 formed on the main substrate 2001.

The main substrate 2001 may include a connector 2006 including a plurality of pins coupled to an external host. The number and an arrangement of the plurality of pins in the connector 2006 may vary based on a communication interface between the electronic system 2000 and the external host. In some implementations, the electronic system 2000 may communicate with the external host using one of interfaces such as USB (Universal Serial Bus), PCI-Express (Peripheral Component Interconnect Express), SATA (Serial Advanced Technology Attachment), M-Phy for UFS (Universal Flash Storage), etc. In some implementations, the electronic system 2000 may operate using power supplied from the external host via the connector 2006. The electronic system 2000 may further include a power management integrated circuit (PMIC) for distributing power supplied from the external host to the main controller 2002 and the semiconductor package 2003.

The main controller 2002 may write data to the semiconductor package 2003 or read data from the semiconductor package 2003, and may improve an operating speed of the electronic system 2000.

The DRAM 2004 may act as a buffer memory for reducing a difference between operation speeds of the semiconductor package 2003 as a data storage space and the external host. The DRAM 2004 included in electronic system 2000 may operate as a cache memory, and may provide a space for temporarily storing data therein in a control operation of the semiconductor package 2003. When the DRAM 2004 is included in the electronic system 2000, the main controller 2002 may further include a DRAM controller for controlling the DRAM 2004 in addition to a NAND controller for controlling the semiconductor package 2003.

The semiconductor package 2003 may include a first semiconductor package 2003a and a second semiconductor package 2003b spaced apart from each other. Each of the first semiconductor package 2003a and the second semiconductor package 2003b may be embodied as a semiconductor package including a plurality of semiconductor chips 2200. Each of the first semiconductor package 2003a and the second semiconductor package 2003b may include a package substrate 2100, semiconductor chips 2200 on the package substrate 2100, adhesive layers 2300 disposed on a bottom face of each of the semiconductor chips 2200, a connection structure 2400 electrically connecting the semiconductor chips 2200 and the package substrate 2100 to each other, and a molding layer 2500 disposed the package substrate 2100 and covering the semiconductor chips 2200 and the connection structure 2400.

The package substrate 2100 may be embodied as a printed circuit board including package upper pads 2130. Each semiconductor chip 2200 may include an input/output pad 2210. The input/output pad 2210 may be embodied as the input/output pad 1101 in FIG. 42.

In some implementations, the connection structure 2400 may be embodied as a bonding wire that electrically connects the input/output pad 2210 and the package upper pads 2130 to each other. Accordingly, in each of the first semiconductor package 2003a and the second semiconductor package 2003b, the semiconductor chips 2200 may be electrically connected to each other in a bonding wire scheme, and may be electrically connected to the package upper pads 2130 of the package substrate 2100. In some implementations, in each of the first semiconductor package 2003a and the second semiconductor package 2003b, the semiconductor chips 2200 may be electrically connected to each other via a connection structure including a through electrode (Through Silicon Via: TSV) instead of the connection structure 2400 using the bonding wire scheme.

In some implementations, the main controller 2002 and the semiconductor chips 2200 may be included in one package. In some implementations, the main controller 2002 and the semiconductor chips 2200 may be mounted on a separate interposer substrate different from the main substrate 2001, and the main controller 2002 and the semiconductor chips 2200 may be connected to each other via a line formed in the interposer substrate.

In some implementations, the package substrate 2100 may be embodied as a printed circuit board. The package substrate 2100 may include a package substrate body 2120, the package upper pads disposed on a top face of the package substrate body 2120, package lower pads 2125 disposed on a bottom face of the package substrate body 2120, or exposed through the bottom face thereof, and internal lines 2135 disposed in the package substrate body 2120 so as to electrically connect the upper pads 2130 and the lower pads 2125 to each other. The upper pads 2130 may be electrically connected to the connection structures 2400. The lower pads 2125 may be connected to the line patterns 2005 of the main substrate 2010 of the electronic system 2000 via conductive connectors 2800 as shown in FIG. 40.

In the electronic system according to some implementations, each of the semiconductor chips 2200 may include the semiconductor memory device as described above using FIGS. 1 to 13. For example, each of the semiconductor chips 2200 may include the peripheral circuit structure PERI and the cell structure CELL stacked on the peripheral circuit structure PERI as described above using FIGS. 1 to 13. By way of example, the cell structure CELL may include a structure 107 including the first insulating layer 106, the source structure 105, and the semiconductor layer 101, the mold structures MS1 and MS2, the channel structure CH, the bit-line BL, the cell contact 150 and the word-line cutting structure WLC as described above using FIGS. 1 to 13. The peripheral circuit structure PERI and the cell structure CELL may be bonded to each other via the first bonding metal 190 and the second bonding metal 290.

As the term is used herein in reference to layers and structures, "disposed on" includes, but is not limited to, arrangements in which a first element is partially embedded in/surrounded by a second element. For example, when a channel structure is described as "disposed on" a plug, the channel structure may protrude into the plug, e.g., so that a topmost face of the channel structure is disposed in the plug. In addition, "disposed on" or "stacked on" does not require any particular vertical ordering in the arrangement of two elements: a given arrangement of a first element and a second element may be described equivalently as "the first element disposed on the second element" and "the second element disposed on the first element." Moreover, when a first element is described as "disposed on" or "stacked on" a second element, one or more layers may be vertically interposed between the first element and the second element. For example, when a plurality of gate electrodes are described as being "disposed on" a semiconductor layer, one or more layers, such as an insulating layer, may be arranged vertically between the plurality of gate electrodes and the semiconductor layer.

## Claims

1. A semiconductor memory device (10, 1100) comprising:
a semiconductor layer (101) including a first face (101a) and a second face (101b, 102b) opposite to the first face (101a) in a first direction (X) directed upward from the first face (101a) to the second face (101b, 102b);
a source structure (105) including:
a plate (104) disposed on the second face (101b, 102b) of the semiconductor layer (101), and
a plug (103) extending from the plate (104) through the semiconductor layer (101);
a plurality of gate electrodes (GSL, WL11 to WL1n, WL21 to WL2n, SSL) disposed on the first face (101a) of the semiconductor layer (101) and sequentially stacked on one another; and
a channel structure (CH) that extends through the plurality of gate electrodes (GSL, WL11 to WL1n, WL21 to WL2n, SSL) and that is disposed on the plug (103), wherein the channel structure (CH) is electrically connected to the source structure (105),
**characterised in that**
the device (10, 1100) further comprises a source contact (180) that extends through the plurality of gate electrodes (GSL, WL11 to WL1n, WL21 to WL2n, SSL) and that is electrically connected to the source structure (105), and
wherein a top face (180_US) of the source contact (180) in the first direction (X) is disposed in a further plug extending from the plate (104) through the semiconductor layer (101).

2. The semiconductor memory device (10, 1100) of claim 1, wherein a width of the plug (103) increases as the plug (103) extends in a direction from the second face (101b, 102b) of the semiconductor layer (101) toward the first face (101a) of the semiconductor layer (101).

3. The semiconductor memory device (10, 1100) of claim 1, wherein the plug (103) includes a first plug and a second plug spaced apart from each other along a direction parallel to the first face (101a) of the semiconductor layer (101), and
wherein the channel structure (CH) includes a first channel structure disposed on the first plug, and a second channel structure disposed on the second plug.

4. The semiconductor memory device (10, 1100) of claim 1, wherein the channel structure (CH) includes a first channel structure and a second channel structure disposed on the plug (103), and spaced apart from each other along a direction parallel to the first face (101a) of the semiconductor layer (101).

5. The semiconductor memory device (10, 1100) of claim 1, wherein a top face of the channel structure (CH) in the first direction (X) is disposed in the plug (103).

6. The semiconductor memory device (10, 1100) of claim 1, wherein the device (1100) further comprises a word-line cutting structure (WLC) that extends through the plurality of gate electrodes (GSL, WL11 to WL1n, WL21 to WL2n, SSL) and cuts the plurality of gate electrodes (GSL, WL11 to WL1n, WL21 to WL2n, SSL), and
wherein a top face of the word-line cutting structure (WLC) in the first direction (X) is disposed in the semiconductor layer (101).

7. The semiconductor memory device (10, 1100) of claim 6, wherein the top face of the word-line cutting structure (WLC) in the first direction (X) is closer to the second face (101b, 102b) of the semiconductor layer (101) than a top face of the channel structure (CH) in the first direction (X).

8. The semiconductor memory device (10, 1100) of claim 6, wherein the word-line cutting structure (WLC) is spaced apart from the source structure (105) along a direction parallel to the first face (101a) of the semiconductor layer (101).

9. The semiconductor memory device (10, 1100) of claim 1, wherein the device (1100) further comprises a cell contact (150) that extends through the plurality of gate electrodes (GSL, WL11 to WL1n, WL21 to WL2n, SSL) and that is electrically connected to at least one of the plurality of gate electrodes (GSL, WL11 to WL1n, WL21 to WL2n, SSL), and
wherein a top face of the cell contact (150) in the first direction (X) is disposed in the semiconductor layer (101).

10. The semiconductor memory device (10, 1100) of claim 9, wherein the top face of the cell contact (150) in the first direction (X) is closer to the second face (101b, 102b) of the semiconductor layer (101) than a top face of the channel structure (CH) in the first direction (X).

11. The semiconductor memory device (10, 1100) of claim 9, wherein the cell contact (150) is spaced apart from the source structure (105) along a direction parallel to the first face (101a) of the semiconductor layer (101).

12. The semiconductor memory device (10, 1100) of claim 1, wherein a gate electrode closest to the first face (101a) of the semiconductor layer (101) among the plurality of gate electrodes (GSL, WL11 to WL1n, WL21 to WL2n, SSL) includes a third face (105a) facing the first face (101a), and
wherein the third face (105a) of the gate electrode is closer to the first face (101a) of the semiconductor layer (101) than a bottommost face of the plug (103) in the first direction (X).

13. The semiconductor memory device (10, 1100) of claim 1, wherein the channel structure (CH) includes a portion, wherein a width of the portion decreases as the portion extends in a direction from the first face (101a) to the second face (101b, 102b) of the semiconductor layer (101).

## Patentansprüche

1. Eine Halbleiterspeichervorrichtung (10, 1100), umfassend:
eine Halbleiterschicht (101) mit einer ersten Fläche (101a) und einer zweiten Fläche (101b, 102b), die der ersten Fläche (101a) in einer ersten Richtung (X) gegenüberliegt, die von der ersten Fläche (101a) nach oben zur zweiten Fläche (101b, 102b) gerichtet ist;
eine Source-Struktur (105), umfassend:
ein Platte (104), die auf der zweiten Fläche (101b, 102b) der Halbleiterschicht (101) angeordnet ist, und
ein Plug (103), der sich von der Platte (104) durch die Halbleiterschicht (101) erstreckt;
eine Mehrzahl von Gate-Elektroden (GSL, WL11 bis WL1n, WL21 bis WL2n, SSL), die auf der ersten Fläche (101a) der Halbleiterschicht (101) angeordnet und nacheinander übereinander gestapelt sind; und
eine Kanalstruktur (CH), die sich durch die Mehrzahl von Gate-Elektroden (GSL, WL11 bis WL1n, WL21 bis WL2n, SSL) erstreckt und auf dem Plug (103) angeordnet ist, wobei die Kanalstruktur (CH) elektrisch mit der Source-Struktur (105) verbunden ist,
**dadurch gekennzeichnet, dass** die Vorrichtung (10, 1100) ferner einen Source-Kontakt (180) umfasst, der sich durch die Mehrzahl von Gate-Elektroden (GSL, WL11 bis WL1n, WL21 bis WL2n, SSL) erstreckt und elektrisch mit der Source-Struktur (105) verbunden ist, und
wobei eine Oberseite (180_US) des Source-Kontakts (180) in der ersten Richtung (X) in einem weiteren Plug angeordnet ist, der sich von der Platte (104) durch die Halbleiterschicht (101) erstreckt.

2. Die Halbleiterspeichervorrichtung (10, 1100) nach Anspruch 1, wobei die Breite des Plugs (103) zunimmt, wenn sich der Plug (103) in einer Richtung von der zweiten Fläche (101b, 102b) der Halbleiterschicht (101) zur ersten Fläche (101a) der Halbleiterschicht (101) erstreckt.

3. Die Halbleiterspeichervorrichtung (10, 1100) nach Anspruch 1, wobei der Plug (103) einen ersten Plug und einen zweiten Plug umfasst, welche entlang einer Richtung parallel zur ersten Fläche (101a) der Halbleiterschicht (101) voneinander beabstandet sind, und
wobei die Kanalstruktur (CH) eine erste Kanalstruktur, die auf dem ersten Plug angeordnet ist, und eine zweite Kanalstruktur, die auf dem zweiten Plug angeordnet ist, umfasst.

4. Die Halbleiterspeichervorrichtung (10, 1100) nach Anspruch 1, wobei die Kanalstruktur (CH) eine erste Kanalstruktur und eine zweite Kanalstruktur umfasst, die auf dem Plug (103) angeordnet sind und entlang einer Richtung parallel zur ersten Fläche (101a) der Halbleiterschicht (101) voneinander beabstandet sind.

5. Die Halbleiterspeichervorrichtung (10, 1100) nach Anspruch 1, wobei eine Oberseite der Kanalstruktur (CH) in der ersten Richtung (X) in dem Plug (103) angeordnet ist.

6. Die Halbleiterspeichervorrichtung (10, 1100) nach Anspruch 1, wobei die Vorrichtung (1100) ferner eine Wortleitungs-Trennstruktur (WLC) umfasst, die sich durch die Mehrzahl von Gate-Elektroden (GSL, WL11 bis WL1n, WL21 bis WL2n, SSL) erstreckt und die Mehrzahl von Gate-Elektroden (GSL, WL11 bis WL1n, WL21 bis WL2n, SSL) trennt, und
wobei eine Oberseite der Wortleitungs-Trennstruktur (WLC) in der ersten Richtung (X) in der Halbleiterschicht (101) angeordnet ist.

7. Die Halbleiterspeichervorrichtung (10, 1100) nach Anspruch 6, wobei die Oberseite der Wortleitungs-Trennstruktur (WLC) in der ersten Richtung (X) näher an der zweiten Fläche (101b, 102b) der Halbleiterschicht (101) liegt als eine Oberseite der Kanalstruktur (CH) in der ersten Richtung (X).

8. Die Halbleiterspeichervorrichtung (10, 1100) nach Anspruch 6, wobei die Wortleitungs-Trennstruktur (WLC) entlang einer Richtung parallel zur ersten Fläche (101a) der Halbleiterschicht (101) von der Source-Struktur (105) beabstandet ist.

9. Die Halbleiterspeichervorrichtung (10, 1100) nach Anspruch 1, wobei die Vorrichtung (1100) ferner einen Zellkontakt (150) umfasst, der sich durch die Mehrzahl von Gate-Elektroden (GSL, WL11 bis WL1n, WL21 bis WL2n, SSL) erstreckt und der elektrisch mit mindestens einer der Mehrzahl von Gate-Elektroden (GSL, WL11 bis WL1n, WL21 bis WL2n, SSL) verbunden ist, und
wobei eine Oberseite des Zellkontakts (150) in der ersten Richtung (X) in der Halbleiterschicht (101) angeordnet ist.

10. Die Halbleiterspeichervorrichtung (10, 1100) nach Anspruch 9, wobei die Oberseite des Zellkontakts (150) in der ersten Richtung (X) näher an der zweiten Fläche (101b, 102b) der Halbleiterschicht (101) liegt als eine Oberseite der Kanalstruktur (CH) in der ersten Richtung (X).

11. Die Halbleiterspeichervorrichtung (10, 1100) nach Anspruch 9, wobei der Zellkontakt (150) entlang einer Richtung parallel zur ersten Fläche (101a) der Halbleiterschicht (101) von der Source-Struktur (105) beabstandet ist.

12. Die Halbleiterspeichervorrichtung (10, 1100) nach Anspruch 1, wobei eine Gate-Elektrode, die der ersten Fläche (101a) der Halbleiterschicht (101) unter der Mehrzahl von Gate-Elektroden (GSL, WL11 bis WL1n, WL21 bis WL2n, SSL) am nächsten liegt, eine dritte Fläche (105a) aufweist, die der ersten Fläche (101a) zugewandt ist, und
wobei die dritte Fläche (105a) der Gate-Elektrode in der ersten Richtung (X) näher an der ersten Fläche (101a) der Halbleiterschicht (101) liegt als die unterste Fläche des Plugs (103).

13. Die Halbleiterspeichervorrichtung (10, 1100) nach Anspruch 1, wobei die Kanalstruktur (CH) einen Abschnitt umfasst, wobei eine Breite des Abschnitts abnimmt, wenn sich der Abschnitt in einer Richtung von der ersten Fläche (101a) zur zweiten Fläche (101b, 102b) der Halbleiterschicht (101) erstreckt.

## Revendications

1. Un dispositif de mémoire à semi-conducteur (10, 1100) comprenant :
une couche semi-conductrice (101) comprenant une première face (101a) et une deuxième face (101b, 102b) opposée à la première face (101a) dans une première direction (X) dirigée vers le haut depuis la première face (101a) vers la deuxième face (101b, 102b) ;
une structure de source (105) comprenant :
une plaque (104) disposée sur la deuxième face (101b, 102b) de la couche semi-conductrice (101), et
une fiche (103) s'étendant depuis la plaque (104) à travers la couche semi-conductrice (101) ;
une pluralité d'électrodes de grille (GSL, WL11 à WL1n, WL21 à WL2n, SSL) disposées sur la première face (101a) de la couche semi-conductrice (101) et empilées séquentiellement les unes sur les autres ; et
une structure de canal (CH) qui s'étend à travers la pluralité d'électrodes de grille (GSL, WL11 à WL1n, WL21 à WL2n, SSL) et qui est disposée sur la fiche (103), dans lequel la structure de canal (CH) est connectée électriquement à la structure de source (105),
**caractérisé en ce que** le dispositif (10, 1100) comprend en outre un contact de source (180) qui s'étend à travers la pluralité d'électrodes de grille (GSL, WL11 à WL1n, WL21 à WL2n, SSL) et qui est électriquement connecté à la structure de source (105), et
dans lequel une face supérieure (180_US) du contact de source (180) dans la première direction (X) est disposée dans une autre fiche s'étendant depuis la plaque (104) à travers la couche semi-conductrice (101).

2. Le dispositif de mémoire à semi-conducteur (10, 1100) selon la revendication 1, dans lequel la largeur de la fiche (103) augmente à mesure que la fiche (103) s'étend dans une direction allant de la deuxième face (101b, 102b) de la couche semi-conductrice (101) vers la première face (101a) de la couche semi-conductrice (101).

3. Le dispositif de mémoire à semi-conducteurs (10, 1100) selon la revendication 1, dans lequel la fiche (103) comprend une première fiche et une deuxième fiche espacées l'une de l'autre dans une direction parallèle à la première face (101a) de la couche semi-conductrice (101), et
dans lequel la structure de canal (CH) comprend une première structure de canal disposée sur la première fiche, et une deuxième structure de canal disposée sur la deuxième fiche.

4. Le dispositif de mémoire à semi-conducteur (10, 1100) selon la revendication 1, dans lequel la structure de canal (CH) comprend une première structure de canal et une deuxième structure de canal disposées sur la fiche (103) et espacées l'une de l'autre dans une direction parallèle à la première face (101a) de la couche semi-conductrice (101).

5. Le dispositif de mémoire à semi-conducteurs (10, 1100) selon la revendication 1, dans lequel une face supérieure de la structure de canal (CH) dans la première direction (X) est disposée dans la fiche (103).

6. Le dispositif de mémoire à semi-conducteurs (10, 1100) selon la revendication 1, dans lequel le dispositif (1100) comprend en outre une structure de coupure de ligne de mots (WLC) qui s'étend à travers la pluralité d'électrodes de grille (GSL, WL11 à WL1n, WL21 à WL2n, SSL) et coupe la pluralité d'électrodes de grille (GSL, WL11 à WL1n, WL21 à WL2n, SSL), et
dans lequel une face supérieure de la structure de coupure de ligne de mots (WLC) dans la première direction (X) est disposée dans la couche semi-conductrice (101).

7. Le dispositif de mémoire à semi-conducteur (10, 1100) selon la revendication 6, dans lequel la face supérieure de la structure de coupure de ligne de mots (WLC) dans la première direction (X) est plus proche de la deuxième face (101b, 102b) de la couche semi-conductrice (101) que la face supérieure de la structure de canal (CH) dans la première direction (X).

8. Le dispositif de mémoire à semi-conducteurs (10, 1100) selon la revendication 6, dans lequel la structure de coupure de ligne de mots (WLC) est espacée de la structure de source (105) dans une direction parallèle à la première face (101a) de la couche semi-conductrice (101).

9. Le dispositif de mémoire à semi-conducteurs (10, 1100) selon la revendication 1, dans lequel le dispositif (1100) comprend en outre un contact de cellule (150) qui s'étend à travers la pluralité d'électrodes de grille (GSL, WL11 à WL1n, WL21 à WL2n, SSL) et qui est connecté électriquement à au moins une de la pluralité d'électrodes de grille (GSL, WL11 à WL1n, WL21 à WL2n, SSL), et
dans lequel une face supérieure du contact de cellule (150) dans la première direction (X) est disposée dans la couche semi-conductrice (101).

10. Le dispositif de mémoire à semi-conducteur (10, 1100) selon la revendication 9, dans lequel la face supérieure du contact de cellule (150) dans la première direction (X) est plus proche de la deuxième face (101b, 102b) de la couche semi-conductrice (101) que la face supérieure de la structure de canal (CH) dans la première direction (X).

11. Le dispositif de mémoire à semi-conducteur (10, 1100) selon la revendication 9, dans lequel le contact de cellule (150) est espacé de la structure de source (105) dans une direction parallèle à la première face (101a) de la couche semi-conductrice (101).

12. Le dispositif de mémoire à semi-conducteur (10, 1100) selon la revendication 1, dans lequel une électrode de grille la plus proche de la première face (101a) de la couche semi-conductrice (101) parmi la pluralité d'électrodes de grille (GSL, WL11 à WL1n, WL21 à WL2n, SSL) comprend une troisième face (105a) faisant face à la première face (101a), et
dans lequel la troisième face (105a) de l'électrode de grille est plus proche de la première face (101a) de la couche semi-conductrice (101) que la face inférieure de la fiche (103) dans la première direction (X).

13. Le dispositif de mémoire à semi-conducteur (10, 1100) selon la revendication 1, dans lequel la structure de canal (CH) comprend une partie dont la largeur diminue à mesure que la partie s'étend dans une direction allant de la première face (101a) à la deuxième face (101b, 102b) de la couche semi-conductrice (101).
